# EUROPEAN PATENT APPLICATION

(11) **EP 4 383 243 A1**
(43) Date of publication of application: **12.06.2024**
(21) Application number: 23212832.2
(22) Date of filing: 28.11.2023
(51) Int. Cl.: G09G 3/3233

(54) **DISPLAY PANEL AND DISPLAY APPARATUS**

(30) Priority: 07.12.2022 KR 20220169732
(71) Applicant: LG Display Co., Ltd., Seoul 07336 (KR)
(72) Inventor: SONG, SangMoo, 10845 Paju-si (KR); PARK, JongHyun, 10845 Paju-si (KR); BAEK, KwangHyun, 10845 Paju-si (KR); YOON, Jungseop, 10845 Paju-si (KR)
(74) Representative: Crew, Alexander Edward Ross

(57) **Abstract**

Disclosed is a display panel comprising a display area including a first area in which first subpixels are disposed and a second area in which second subpixels are disposed, wherein each of the first and second subpixels includes a first light emitting element driven through a first light emitting control transistor, a second light emitting element driven through a second light emitting control transistor, a first lens region disposed on the first light emitting element, and a second lens region disposed on the second light emitting element, wherein the first lens region and the second lens region differently control a viewing angle in a first direction, the first light emitting control transistor of the first subpixel is controlled by a first light emitting control signal, the second light emitting control transistor of the first subpixel is controlled by a second light emitting control signal, the first light emitting control transistor of the second subpixel is controlled by a third light emitting control signal, and the second light emitting control transistor of the second subpixel is controlled by a fourth light emitting control signal.

## Description

### CROSS-REFERENCE TO RELATED APPLICATION

This application claims the benefit of and the priority to Korean Patent Application No. 10-2022-0169732 filed on December 7, 2022, in the Republic of Korea.

### BACKGROUND

### Technical Field

The present disclosure relates to a display panel and a display apparatus capable of adjusting a ratio of a plurality of regions for independently controlling a viewing angle in a display area.

### Discussion of the Related art

Electronic devices of various fields include a display apparatus for displaying an image. For example, a plurality of display apparatuses for providing desired information or contents to a driver and a passenger may be applied to a vehicle.

Among the display apparatuses mounted on the vehicle, the size of display apparatus disposed at the center of a dashboard becomes large. This display apparatus may comprise a first region of a wide viewing angle mode for both the driver and passenger and a second region with a switchable mode capable of selectively providing the wide viewing angle mode or narrow viewing angle mode.

However, since the first region and the second region of the display device are fixedly provided, there is an inconvenience or limitation in which an image displayed on the fixed region may be limited in where it is viewable from, i.e. among a driver's seat or a passenger seat.

The disclosure of the above-described background art is owned by the inventor of the present disclosure to devise the present disclosure or is technical information acquired by a process of devising the present disclosure, but may not be regarded as the known art disclosed to the general public before the present disclosure is disclosed.

### SUMMARY

The present disclosure is directed to a display panel and a display apparatus that substantially obviate one or more of the problems due to limitations and disadvantages of the related art.

An aspect of the present disclosure is to provide a display panel and a display apparatus capable of adjusting a ratio of a plurality of regions for independently controlling a viewing angle in a display area.

Additional features and aspects will be set forth in the description that follows, and in part will be apparent from the description, or can be learned by practice of the inventive concepts provided herein. Other features and aspects of the inventive concepts can be realized and attained by the structure particularly pointed out in the written description, or derivable therefrom, and the claims hereof as well as the appended drawings

To achieve these and other aspects of the inventive concepts, as embodied and broadly described herein, a display panel may include a display area including a first area in which first subpixels are disposed and a second area in which second subpixels are disposed, wherein each of the first and second subpixels includes a first light emitting element driven through a first light emitting control transistor, a second light emitting element driven through a second light emitting control transistor, a first lens region disposed on the first light emitting element, and a second lens region disposed on the second light emitting element, wherein the first lens region and the second lens region differently control a viewing angle in a first direction, the first light emitting control transistor of the first subpixel is controlled by a first light emitting control signal, the second light emitting control transistor of the first subpixel is controlled by a second light emitting control signal, the first light emitting control transistor of the second subpixel is controlled by a third light emitting control signal, and the second light emitting control transistor of the second subpixel is controlled by a fourth light emitting control signal.

in accordance with another aspect of the present disclosure, a display apparatus may include a display panel with a display area including a first area in which first subpixels are disposed and a second area in which second subpixels are disposed, wherein each of the first and second subpixels includes a first light emitting element driven through a first light emitting control transistor, a second light emitting element driven through a second light emitting control transistor, a first lens region disposed in a light traveling path of the first light emitting element, and a second lens region disposed in a light traveling path of the second light emitting element, wherein the first lens region and the second lens region control different viewing angles in a first direction, and a first emission control driver configured to supply a first light emitting control signal for controlling the first light emitting control transistor of the first subpixel, a second emission control driver configured to supply a second light emitting control signal for controlling the second light emitting control transistor of the first subpixel, a third emission control driver configured to supply a third light emitting control signal for controlling the first light emitting control transistor of the second subpixel, and a fourth emission control driver configured to supply a fourth light emitting control signal for controlling the second light emitting control transistor of the second subpixel.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain various principles of the disclosure. In the drawings:
FIG. 1 is a block diagram schematically illustrating a configuration of a display apparatus according to one embodiment;
FIG. 2 illustrates a structure in which a display apparatus according to one embodiment of the present disclosure is applied to a vehicle;
FIGs. 3A to 3C illustrate examples in which the ratio of first and second areas is changed in a display panel according to one embodiment of the present disclosure;
FIG. 4 is a plan view schematically illustrating a pixel structure of a display panel according to one embodiment of the present disclosure;
FIGs. 5A and 5B are perspective views illustrating first and second lens structures of each subpixel according to one embodiment of the present disclosure;
FIGs. 6A to 8B illustrate a ratio change and a viewing angle control method of first and second areas in the display panel according to one embodiment of the present disclosure;
FIG. 9 is a plan view illustrating a pixel structure of the display panel according to one embodiment of the present disclosure;
FIG. 10 is a cross-sectional view of the first lens region along I-I' of FIG. 9;
FIG. 11 is a cross-sectional view of the second lens region along II-II' of FIG. 9;
FIG. 12 illustrates a configuration of each subpixel in first and second areas of a display panel according to one embodiment of the present disclosure;
FIG. 13 illustrates a configuration of each subpixel in first and second areas of a display panel according to one embodiment of the present disclosure;
FIG. 14 schematically illustrates first and second areas and emission control drivers of the display panel according to one embodiment of the present disclosure;
FIG. 15 illustrates input/output waveforms of the emission control drivers according to one embodiment of the present disclosure;
FIG. 16 schematically illustrates first to fourth areas and emission control drivers of a display panel according to one embodiment of the present disclosure; and
FIG. 17 is an equivalent circuit diagram illustrating a configuration of any one stage in any one emission control driver according to one embodiment of the present disclosure.

### DETAILED DESCRIPTION OF THE DISCLOSURE

Advantages and features of the present disclosure, and implementation methods thereof will be clarified through following aspects described with reference to the accompanying drawings. The present disclosure may, however, be embodied in different forms and should not be construed as limited to the aspects set forth herein. Rather, these aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing aspects of the present disclosure are merely an example, and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have', and 'include' described in the present specification are used, another part can be added unless 'only' is used. The terms of a singular form can include plural forms unless referred to the contrary.

in construing an element, the element is construed as including an error range although there is no explicit description.

in describing a position relationship, for example, when a position relation between two parts is described as "on," "over," "under," and "next," one or more other parts can be disposed between the two parts unless a more limiting term, such as "just" or "direct(ly)" is used.

in describing a time relationship, for example, when the temporal order is described as, for example, "after," "subsequent," "next," and "before," a case which is not continuous can be included unless a more limiting term, such as "just," "immediate(ly)," or "direct(ly)" is used.

It will be understood that, although the terms "first," "second," etc. can be used herein to describe various elements, these elements should not be limited by these terms. These terms are only used to distinguish one element from another. For example, a first element could be termed a second element, and, similarly, a second element could be termed a first element, without departing from the scope of the present disclosure.

in describing the elements of the present disclosure, the terms "first," "second," "A," "B," "(a)," "(b)," etc., can be used. These terms are intended to identify the corresponding elements from the other elements, and basis, order, or number of the corresponding elements should not be limited by these terms. As for the expression that an element or a layer is "connected," "coupled," or "adhered" to another element or layer, the element or layer can not only be directly connected or adhered to another element or layer, but also be indirectly connected or adhered to another element or layer with one or more intervening elements or layers "disposed" between the elements or layers, unless otherwise specified.

The term "at least one" should be understood as including any and all combinations of one or more among the associated listed elements. For example, the meaning of "at least one or more of a first element, a second element, and a third element" denotes the combination of all elements proposed from two or more of the first element, the second element, and the third element as well as the first element, the second element, or the third element.

Features of various aspects of the present disclosure can be partially or overall coupled to or combined with each other, and can be variously inter-operated with each other and driven technically as those skilled in the art can sufficiently understand. The aspects of the present disclosure can be carried out independently from each other, or can be carried out together in co-dependent relationship.

Hereinafter, the aspect of the present disclosure will be described with reference to the accompanying drawings. Since a scale of each of elements shown in the accompanying drawings is different from an actual scale for convenience of description, the present disclosure is not limited to the shown scale. Further, all the components of each display device according to all embodiments of the present disclosure are operatively coupled and configured.

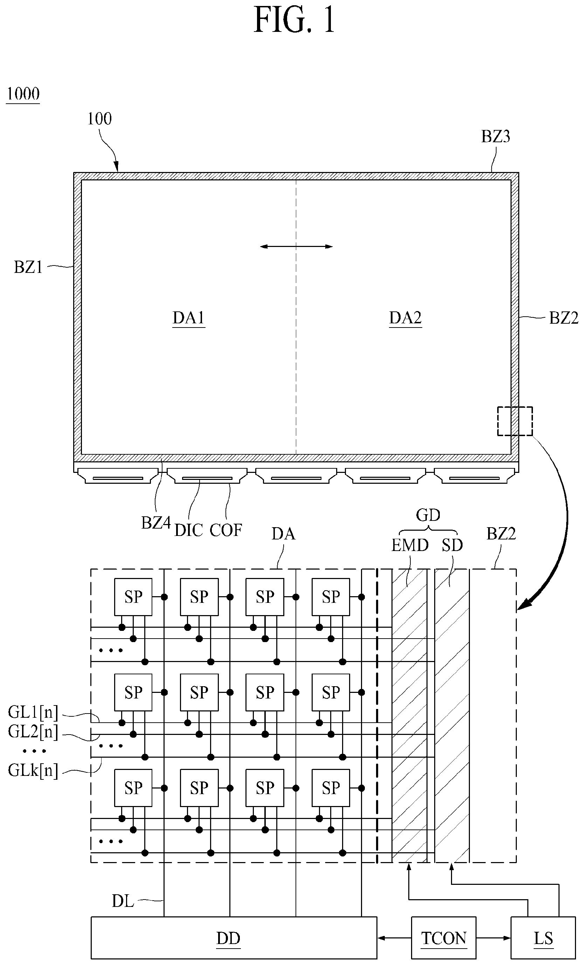

FIG. 1 is a block diagram schematically illustrating a configuration of a display apparatus according to one embodiment.

The display apparatus according to one embodiment of the present disclosure may be an electroluminescent display apparatus including an organic light emitting diode OLED display device, a quantum dot light emitting diode display device, or an inorganic light emitting diode display device. The display apparatus according to one embodiment of the present disclosure may be a micro light emitting diode LED display apparatus.

Referring to FIG. 1, the display apparatus according to one embodiment of the present disclosure may include a display panel 100, a gate driver GD embedded in the display panel 100, a data driver DD connected to the display panel 100, a timing controller TCON for controlling the gate driver GD and the data driver DD, and a level shifter LS connected between the timing controller TCON and the gate driver GD.

The display panel 100 may include a display area DA for displaying an image, and a bezel area BZ1∼BZ4 disposed in the periphery to surround the display area DA.

The display panel 100 displays an image by using the display area DA with a plurality of subpixels arranged in a matrix form. The display area DA may include a plurality of pixel row lines and a plurality of pixel column lines provided with a plurality of subpixels SP.

Each subpixel SP may be any one of a red subpixel for emitting red light, a green subpixel for emitting green light, a blue subpixel for emitting blue light, and a white subpixel for emitting white light. A unit pixel may include at least two subpixels.

Each subpixel SP may comprise a pixel circuit including first and second light emitting elements and a plurality of transistors for independently driving the first and second light emitting elements, a first lens region disposed on the first light emitting element, and a second lens region disposed on the second light emitting element. The first lens region and the second lens region may differently control a light emission angle, that is, a viewing angle. In other words, light emitted from the first lens region may have a different viewing angle, i.e. a different viewing angle range, to light emitted from the second lens region. Throughout this description, the first lens region and/or the first lens LZ1, and the second lens region and/or the second lens LZ2 may be considered to be optical control elements capable of controlling the viewing angle of light emitted therefrom. As an example, the first lens region disposed on the first light emitting element may include a first optical control element disposed on the first light emitting element. Similarly, the second lens region disposed on the second light emitting element may include a second optical control element disposed on the second light emitting element. The first and second optical control elements may respectively comprise the first lens LZ1 and the second lens LZ2 discussed herein, but the first and second optical control elements are not limited thereto and other optical control elements may alternatively be used.

For example, each subpixel SP may drive the first light emitting element to implement a wide viewing angle mode or a share mode through the first lens region and may drive the second light emitting element to implement a narrow viewing angle mode or a privacy mode for limiting a viewing angle through the second lens region. The narrow viewing angle mode corresponds to a mode having a narrow viewing angle in comparison to that of the wide viewing angle. More generally, a wide viewing angle may be considered to be a first viewing angle and a narrow viewing angle may be considered to be a second viewing angle.

Accordingly, the display apparatus or the display panel 100 may control the viewing angle of each subpixel SP by selectively driving the first light emitting element and/or the second light emitting element for each subpixel SP. A detailed description thereof will be provided as follows.

in the display apparatus or the display panel 100, the display area DA may be divided into a first area DA1 and a second area DA2. The first area DA1 and the second area DA2 may be capable of being controlled to have different viewing angles and may be operated dividedly, separately or independently. Through adjusting respective viewing angles in the first area DA1 and the second area DA2 it is possible to adjust the ratio or area of the first area DA1 and the second area DA2. More generally, the wide viewing angles provided by the first area DA1 and the second area DA2 may be considered to be first viewing angles and the narrow viewing angles provided by the first area DA1 and the second area DA2 may be considered to be second viewing angles. In these examples, the first viewing angle of the first area DA1 may differ from the first viewing angle of the second area DA2. Similarly, the second viewing angle of the first area DA1 may differ from the second viewing angle of the second area DA2.

For example, the first area DA1 may operate in the wide viewing angle mode through the first lens region by driving the first light emitting element in each subpixel SP and may operate in the narrow viewing angle mode through the second lens region by driving the second light emitting element. The second area DA2 may operate in the narrow viewing angle mode through the second lens region by driving the second light emitting element in each subpixel SP and may operate in the wide viewing angle mode through the first lens region by driving the first light emitting element. The first area DA1 and the second area DA2 may be driven in different viewing angle modes or may be driven in the same viewing angle mode.

The display apparatus or the display panel 100 may adjust the ratio or area of the first area DA1 and the second area DA2 in the display area DA by selectively driving the first and second light emitting elements in each subpixel SP. For example, the first viewing area DA1 may be intended or configured by default to provide a wide viewing angle and the second viewing area DA2 may be intended or configured by default to provide a narrow viewing angle. A first subset of subpixels SP in a first spatial region of the first viewing area DA1 may be driven to provide a wide viewing angle and a second subset of subpixels SP in a second spatial region of the first viewing area DA1 may be driven to provide a narrow viewing angle. The subpixels SP in the second viewing area DA2 may be driven to provide a narrow viewing angle. The second subset of subpixels SP in the second spatial region of the first viewing area DA1 may be adjacent to the second viewing area DA2. As such, the second viewing area DA2 with the narrow viewing angle has effectively been extended to include some of the area of the second viewing area DA1 and the first viewing area DA1 with the wide viewing angle has effectively been shortened.

The display panel 100 further includes a plurality of signal lines including a data line DL, gate lines GL1[n], GL2[n], ..., GLk[n] ('k' and 'n' are integers), a power line, and other signal lines connected to each subpixel SP.

The display panel 100 according to one embodiment of the present disclosure may further include a touch sensor screen disposed in the display area DA and configured to sense a user's touch.

The display panel 100 according to one embodiment of the present disclosure may be a touch display panel in which a touch sensor array is embedded. For example, the display panel 100 according to one embodiment of the present disclosure may comprise a pixel array including a circuit element layer having a plurality of transistors disposed on a substrate and a light emitting element layer having a plurality of light emitting elements disposed on the circuit element layer, an encapsulation layer disposed on the pixel array and configured to encapsulate the light emitting element layer, a touch sensor array having a plurality of touch electrodes disposed on the encapsulation layer, and a lens array having first and second lenses disposed on the touch sensor array. The display panel 100 according to one embodiment of the present disclosure may further include an optical film, an optical clear adhesive OCA, a cover substrate, and a protection film sequentially disposed on the lens array. The display panel 100 according to one embodiment of the present disclosure may further include a color filter array including a color filter and a black matrix disposed between the touch sensor array and the lens array.

The gate driver GD may be disposed on/in at least one of the plurality of bezel areas BZ1∼BZ2 disposed in the periphery of the display area DA. For example, the gate driver GD may be disposed on/in any one of the first and second bezel areas BZ1 and BZ2 facing each other with the display area DA interposed therebetween, or may be disposed on both sides, i.e. on/in both of the first and second bezel areas BZ1 and BZ2. The gate driver GD may be disposed in a gate-in-panel GIP type including the transistors formed in the same process as transistors disposed in the display area DA.

The gate driver GD may include an emission control driver EMD for driving the plurality of gate lines among the plurality of gate lines GL1[n]~GLk[n] connected to the subpixels SP of each pixel row line, and a scan driver SD for driving at least one gate line.

The number of gate lines GL1[n]~GLk[n] connected to the subpixels SP of each pixel row line, the number of scan drivers SD, and the number of emission control drivers EMD are not limited to those illustrated in FIG. 1, and may be variously changed according to a detailed configuration of the pixel circuit constituting each subpixel SP.

Each of the scan driver SD and the emission control driver EMD may be operated by receiving a plurality of gate control signals supplied from the timing controller TCON through the level shifter LS. According to one embodiment of the present disclosure, each of the scan driver SD and the emission control driver EMD may be supplied with the plurality of gate control signals from the timing controller TCON.

The level shifter LS receives control signals from the timing controller TCON and performs level shifting or logic processing to generate the plurality of gate control signals and supply the gate control signals to the scan driver SD and the emission control driver EMD.

The scan driver SD may supply at least one scan signal to each of the plurality of pixel row lines by using the plurality of gate control signals supplied from the level shifter LS or the timing controller TCON. The scan driver SD may supply at least one scan signal to at least one gate line among the plurality of gate lines GL1[n]~GLk[n] connected to the subpixels SP of each pixel row line.

The emission control driver EMD may supply a plurality of light emitting control signals to each of the plurality of pixel lines by using the plurality of gate control signals supplied from the level shifter LS or the timing controller TCON. The emission control driver EMD may supply the plurality of light emitting control signals to the plurality of gate lines among the plurality of gate lines GL1[n]~GLk[n] connected to the subpixels SP of each pixel row line, respectively. To this end, the emission control driver EMD may include the plurality of emission control drivers EMD.

The emission control driver EMD according to one embodiment of the present disclosure may selectively control the driving of the first light emitting element and the second light emitting element in each subpixel SP by using the plurality of light emitting control signals supplied to each subpixel SP. A detailed description thereof will be provided as follows.

The plurality of transistors disposed in the display area DA of the display panel 100 and the bezel area BZ1∼BZ4 including the gate driver GD may comprise at least one of an LTPS transistor using a low temperature polysilicon (LTPS) semiconductor and an oxide transistor using a metal-oxide semiconductor. The display panel 100 according to one embodiment of the present disclosure may be configured such that the LTPS transistor and the oxide transistor coexist to reduce power consumption.

The data driver DD may convert digital data supplied together with data control signals from the timing controller TCON into an analog data signal and may supply each data voltage to a respective data line DL of the display panel 100. The data driver DD may convert the digital data into the analog data voltage by using grayscale voltages in which a plurality of reference gamma voltages supplied from a gamma voltage generator (not shown) are subdivided.

The data driver DD may include at least one data drive integrated circuit IC DIC which drives the plurality of data lines DL disposed in the display panel 100. Each data drive IC DIC may be individually mounted on each circuit film COF. The circuit film COF on which the data drive IC DIC is mounted may be bonded to the bezel area BZ3 in which a pad area of the display panel 100 is disposed through an anisotropic conductive film ACF. The circuit film COF may be a chip on film COF. In addition to the COF, a flexible printed circuit board FPC or a flexible flat cable connect FFC may be used.

The timing controller TCON may control the gate driver GD and the data driver DD by using timing control signals supplied from a host system and timing setting information stored therein.

The timing controller TCON according to one embodiment of the present disclosure may generate the plurality of gate control signals for controlling the driving timing of the gate driver GD and may supply the gate control signals to the gate driver GD. The timing controller TCON according to one embodiment of the present disclosure may generate control signals for timing control and may supply the generated control signals for timing control to the level shifter LS so that the plurality of gate control signals may be generated in the level shifter LS and may be supplied to the gate driver GD.

The timing controller TCON may generate the plurality of data control signals for controlling the driving timing of the data driver DD and may supply the data control signals to the data driver DD. The controller TCON according to one embodiment of the present disclosure may receive input image data and may perform various image processing including image quality correction, deterioration correction, and luminance correction for the reduction of power consumption, and then may supply the image-processed data to the data driver DD.

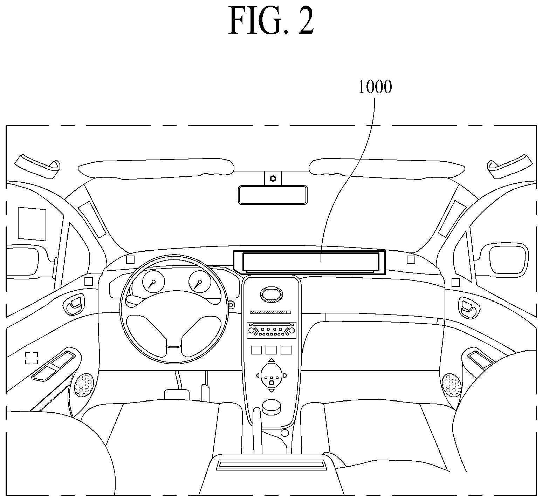

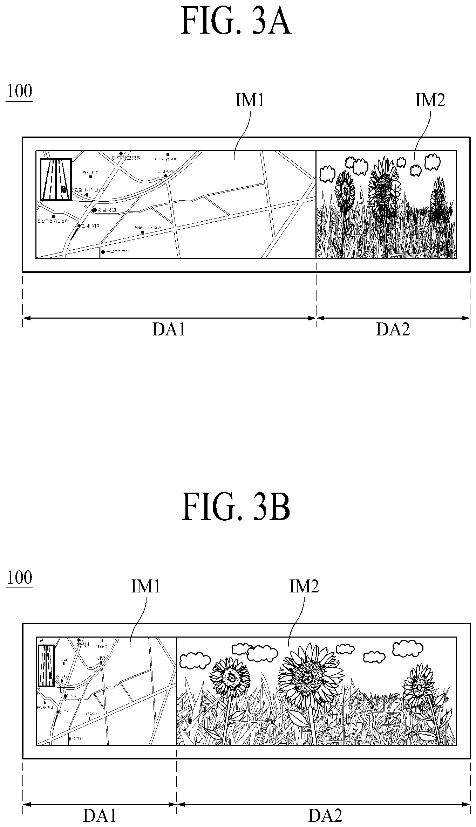

FIG. 2 illustrates a structure in which a display apparatus according to one embodiment of the present disclosure is applied to a vehicle, and FIGs. 3A to 3C illustrate examples in which the ratio of first and second areas is changed in a display panel according to one embodiment of the present disclosure.

Referring to FIGs. 2 to 3C, the display apparatus 1000 according to one embodiment of the present disclosure may be disposed at the center of a dashboard of a vehicle to provide an image to both a driver and a passenger of a passenger seat. The display panel 100 of the display apparatus 1000 may include a first area DA1 and a second area DA2, and a ratio or relative size of these areas may vary, i.e. the respective areas of the first area DA1 and the second area DA2 may vary.

According to one embodiment of the present disclosure, the first area DA1 may be expressed as a center information display CID area or a share mode area, and the second area DA2 may be expressed as a co-driver display area or a switchable privacy mode area.

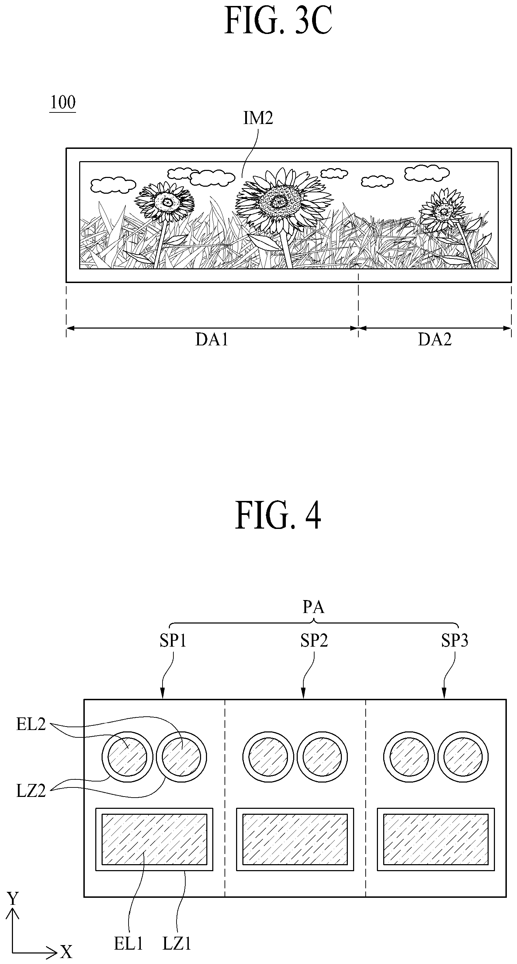

Referring to FIGs. 3A and 3B, the first area DA1 of the display panel 100 may provide a first image IM1 having a wide viewing angle in a left-right direction to the driver and the passenger of the passenger seat, and the second area DA2 may provide a second image IM2 having a narrow viewing angle in a left-right direction to the passenger so as not to disturb the driver's driving. Referring to FIG. 3C, when the driver does not drive, both the first area DA1 and the second area DA2 of the display panel 100 may provide the second image IM2 having the wide viewing angle in a left-right direction to the driver and the passenger.

For example, the first area DA1 of the display panel 100 may be driven in a wide viewing angle mode, and the second area DA2 may be driven in a viewing angle switching mode capable of selectively providing the wide viewing angle mode or narrow viewing angle mode.

The display apparatus 1000 according to one embodiment of the present disclosure selectively drives first and second light emitting elements in each subpixel SP according to the viewing angle mode, for example, the narrow viewing angle mode and/or wide viewing angle mode so that it is possible to control the viewing angle of the first area DA1 and the second area DA2 and to vary the ratio or areas of the first area DA1 and the second area DA2 in the display panel 100.

The display apparatus 1000 according to one embodiment of the present disclosure is not limited to the display apparatus for the vehicle and may be applied to various display apparatuses such as a mobile display, an IT display, and a TV display.

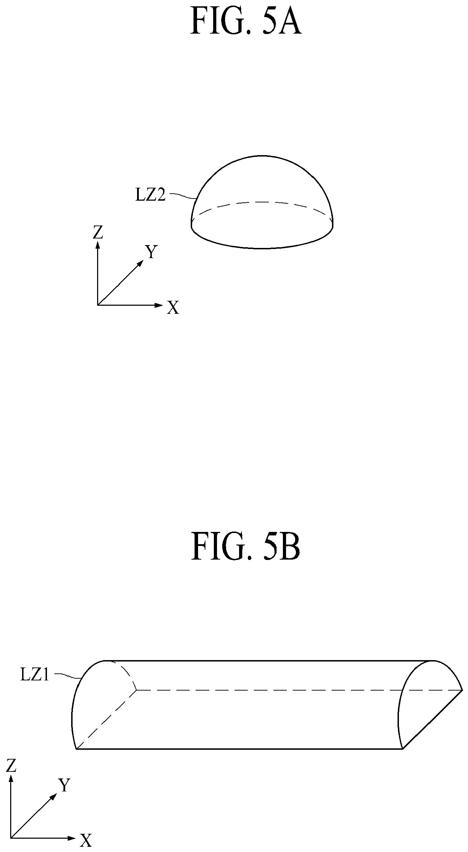

FIG. 4 is a plan view schematically illustrating a pixel structure of a display panel according to one embodiment of the present disclosure, and FIGs. 5A and 5B are perspective views illustrating first and second lens structures of each subpixel according to one embodiment of the present disclosure.

Referring to FIG. 4, each pixel PA or each pixel area in the display apparatus according to one embodiment of the present disclosure may include a plurality of subpixels SP1, SP2, and SP3.

Each of the plurality of subpixels SP1, SP2, and SP3 may include a first light emitting element EL1, a second light emitting element EL2, a first lens LZ1 disposed on the first light emitting element EL1, and a second lens LZ2 disposed on the second light emitting element EL2.

in the embodiment, the first lens LZ1 may be disposed on a light traveling path of the first light emitting element EL1. In other words, the first lens LZ1 may be disposed or configured such that a light emitted from the first light emitting element EL1 passes through the first lens LZ1. The second lens LZ2 may be disposed on a light traveling path of the second light emitting element EL2. In other words, the second lens LZ2 may be disposed or configured such that a light emitted from the second light emitting element EL2 passes through the second lens LZ2.

in each of the subpixels SP1, SP2, and SP3, the second light emitting element EL2 may include a plurality of second light emitting elements EL2 or second light emitting regions, and a plurality of second lenses LZ2 may be individually disposed in the light traveling paths of the plurality of second light emitting elements EL2 or second light emitting regions. In other words, each of the plurality of second light emitting elements EL2 may correspond to a respective second lens LZ2 disposed or configured such that a light emitted from the second light emitting element EL2 passes through the respective second lens LZ2.The plurality of second light emitting elements EL2 or second light emitting regions may be connected in parallel in each of the subpixels SP1, SP2, and SP3.

The region in which the first lens LZ1 is disposed in each of the subpixels SP1, SP2, and SP3 may be expressed as a first lens region, and the region in which the plurality of second lenses LZ2 are disposed may be represented as a second lens region.

Referring to FIG. 5B, the first lens LZ1 may be a half-cylindrical lens elongated in a first direction X. In examples, the first lens LZ1 may be planar, and may have a bar shape, a rectangular shape, or generally any polygon shape extending in a first direction, where the first direction and a second direction are perpendicular to one another, the first direction being longer than the second direction. The corners of the first lens LZ1 may be tapered, or chamfered. Referring to FIG. 5A, the second lens LZ2 may be a half-spherical or hemispherical lens.

in FIGs. 5A and 5B, the first direction X may be expressed in a left-right direction, a widthwise direction, a horizontal direction, or an X-axis direction. In other words, for a display apparatus 1000 or display panel 100 disposed as depicted in FIG. 2, the first direction X may be in a left-right direction extending between a driver side of the vehicle and a passenger side of the vehicle. The second direction Y may be expressed in a vertical direction or a Y axis direction. The third direction Z may be expressed in a front-rear direction, a thickness direction of the display panel 100, or a Z-axis direction.

The first lens LZ1 and the second lens LZ2 may control (limit) the viewing angle in the left-right direction X and may equally control (limit) the viewing angle in the vertical direction Y.

For example, the first lens LZ1 may control the viewing angle to provide the wide viewing angle since the traveling path of the light emitted from the first light emitting element EL1 is not limited within a specific angle in the left-right direction X, and the second lens LZ2 may control the viewing angle to provide the narrow viewing angle by limiting the traveling path of the light emitted from the second light emitting element EL2 to be within a specific angle in the left-right direction X.

Both the first lens LZ1 and the second lens LZ2 may control the viewing angle to provide the narrow viewing angle by limiting the light traveling path within a specific angle in the vertical direction Y. According to one embodiment of the present disclosure, when the display apparatus 1000 is applied to the vehicle as shown in FIG. 2, images displayed on the first and second areas DA1 and DA2 of the display panel 100 are reflected by the front glass of the vehicle to prevent the driver's view from being disturbed.

When the first light emitting element EL1 is driven in each of the subpixels SP1, SP2, and SP3, the corresponding pixel PA may operate in the wide viewing angle mode in which the viewing angle of the left and right directions X is not limited. When the second light emitting element EL2 is driven in each of the first to third subpixels SP1, SP2, and SP3, the corresponding pixel PA may operate in the narrow viewing angle mode for limiting the viewing angle in the left-right direction X. The wide viewing angle mode may be expressed as a first mode, and the narrow viewing angle mode may be expressed as a second mode.

By switching the driving of the first light emitting element EL1 and the driving of the second light emitting element EL2 of the subpixels SP1, SP2, and SP3 in each pixel PA, each pixel PA may switch between the wide viewing angle mode and the narrow viewing angle mode.

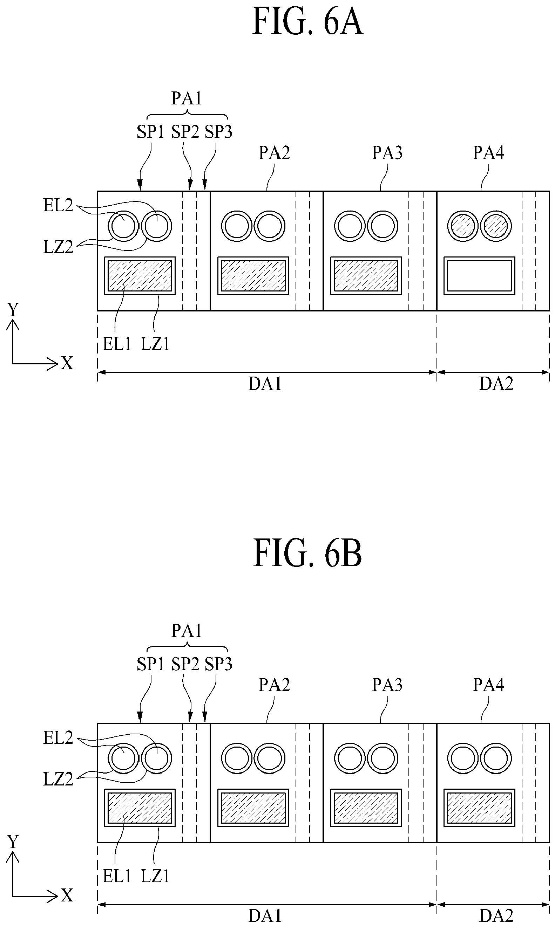

FIGs. 6A to 8B illustrate a ratio change and a viewing angle control method of first and second areas in the display panel according to one embodiment of the present disclosure.

In FIGs. 6A to 8B, the four pixel areas PA1 to PA4 among the plurality of pixel areas of the display panel according to one embodiment of the present disclosure will be described.

Each of the pixel areas PA1 to PA4 may include a plurality of subpixels SP1, SP2, and SP3. Each of the subpixels SP1, SP2, and SP3 may include a first light emitting element EL1 and a first lens LZ1 which are overlapped with each other, and a second light emitting element EL2 and a second lens LZ2 which are overlapped with each other. A region in which the first lens LZ1 is disposed in each of the subpixels SP1, SP2, and SP3 may be expressed as a first lens region, and a region in which the plurality of second lenses LZ2 are disposed may be expressed as a second lens region.

Referring to FIGs. 6A and 6B, in the case of a display apparatus according to one embodiment of the present disclosure, the pixel areas PA1, PA2, PA3 of the display area may be operated as a first area DA1 and the pixel area PA4 may be operated as a second area DA2 according to an option selection. The area (ratio) of the first area DA1 may be larger than that of the second area DA2. Each of the first area DA1 and the second area DA2 may switch between the wide viewing angle mode and the narrow viewing angle mode.

Referring to FIG. 6A, the pixel areas PA1, PA2, and PA3 of the first area DA1 may control the viewing angle to provide the wide viewing angle mode through the first lens LZ1 by driving the first light emitting element EL1, and the pixel area PA4 of the second area DA2 may control the viewing angle to provide the narrow viewing angle mode through the second lens LZ2 by driving the second light emitting element E2.

Referring to FIG. 6B, all the pixel areas PA1, PA2, PA3, and PA4 of the first area DA1 and the second area DA2 may control the viewing angle in the wide viewing angle mode through the first lens LZ1 by driving the first light emitting element EL1.

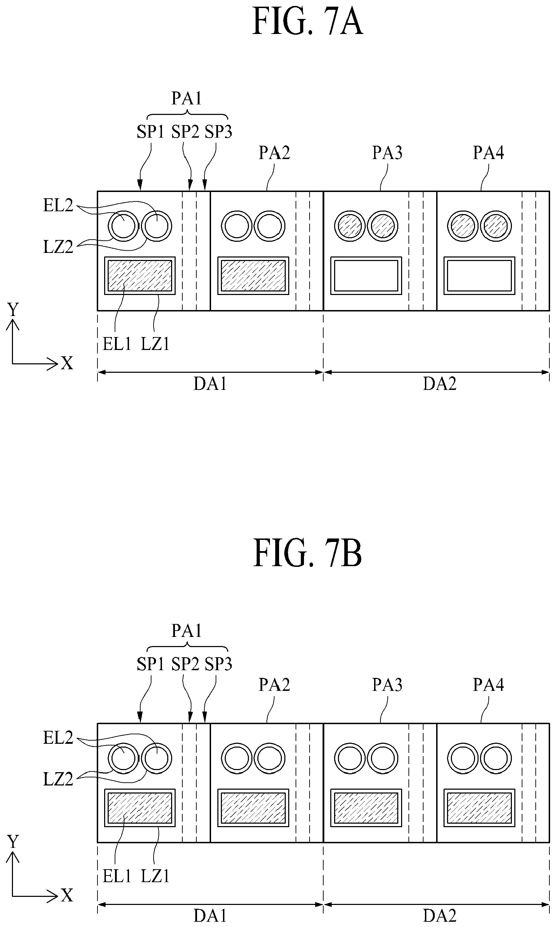

Referring to FIGs. 7A and 7B, in the case of a display apparatus according to one embodiment of the present disclosure, the pixel areas PA1 and PA2 of display area may be operated as a first area DA1 and the pixel areas PA3 and PA4 may be operated as a second area DA2 according to an option selection. The first area DA1 may have the same area (ratio) as the second area DA2. At least one of the first area DA1 and the second area DA2 may switch between the wide viewing angle mode and the narrow viewing angle mode.

Referring to FIG. 7A, the pixel areas PA1 and PA2 of the first area DA1 may control the viewing angle to provide the wide viewing angle mode through the first lens LZ1 by driving the first light emitting element EL1, and the pixel areas PA3 and PA4 of the second area DA2 may control the viewing angle to provide the narrow viewing angle mode through the second lens LZ2 by driving the second light emitting element EL2.

Referring to FIG. 7B, all the pixel areas PA1, PA2, PA3, and PA4 of the first area DA1 and the second area DA2 may control the viewing angle to provide the wide viewing angle mode through the first lens LZ1 by driving the first light emitting element EL1.

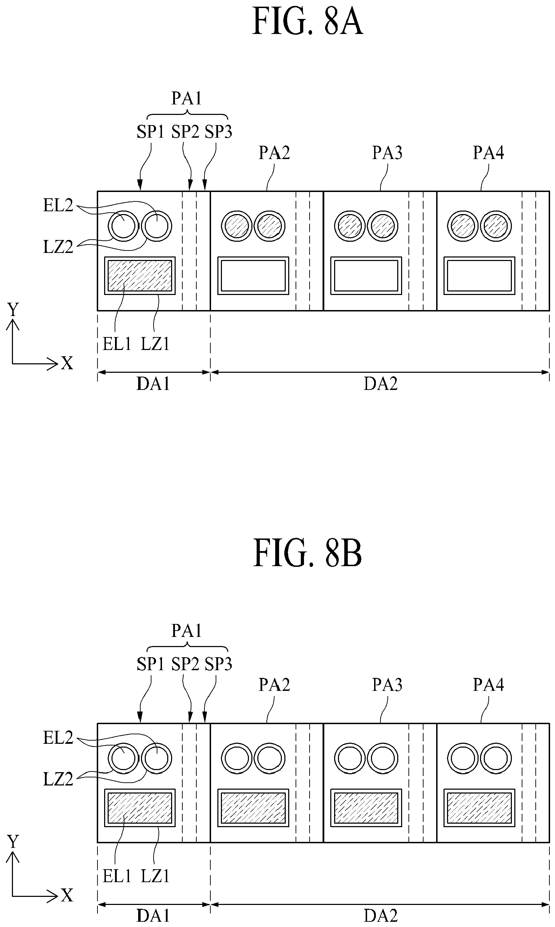

Referring to FIGs. 8A and 8B, in the case of a display apparatus according to one embodiment of the present disclosure, the pixel area PA1 of display area may be operated as a first area DA1 and the pixel areas PA2, PA3, and PA4 may be operated as a second area DA2 according to an option selection. The area (ratio) of the first area DA1 may be smaller than that of the second area DA2. At least one of the first area DA1 and the second area DA2 may switch between the wide viewing angle mode and the narrow viewing angle mode.

Referring to FIG. 8A, the pixel area PA1 of the first area DA1 may control the viewing angle to provide the wide viewing angle mode through the first lens LZ1 by driving the first light emitting element EL1, and the pixel areas PA2, PA3, PA4 of the second area DA2 may control the viewing angle to provide the narrow viewing angle mode through the second lens LZ2 by driving the second light emitting element EL2.

Referring to FIG. 8B, the pixel areas PA1, PA2, PA3, and PA4 of the first area DA1 and the second area DA2 may control the viewing angle to provide the wide viewing angle mode through the first lens LZ1 by driving the first light emitting element EL1.

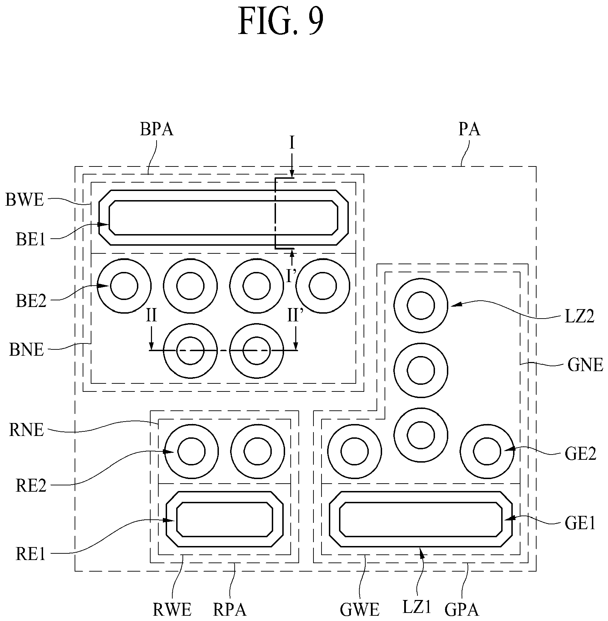

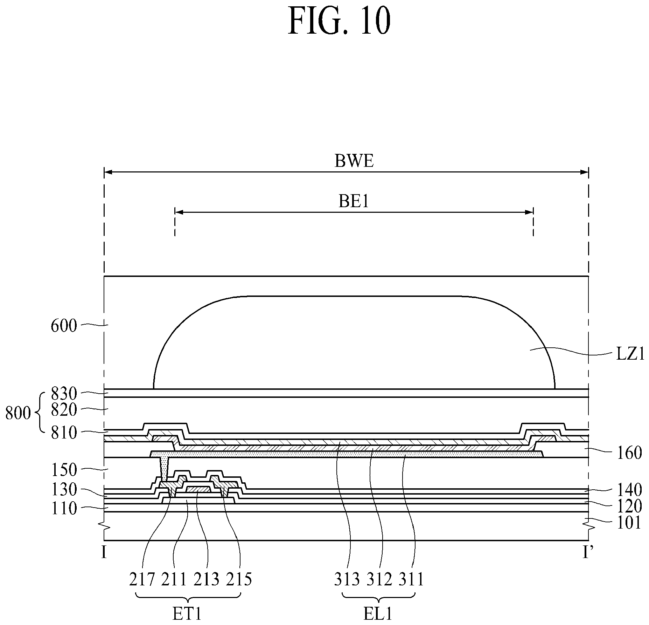

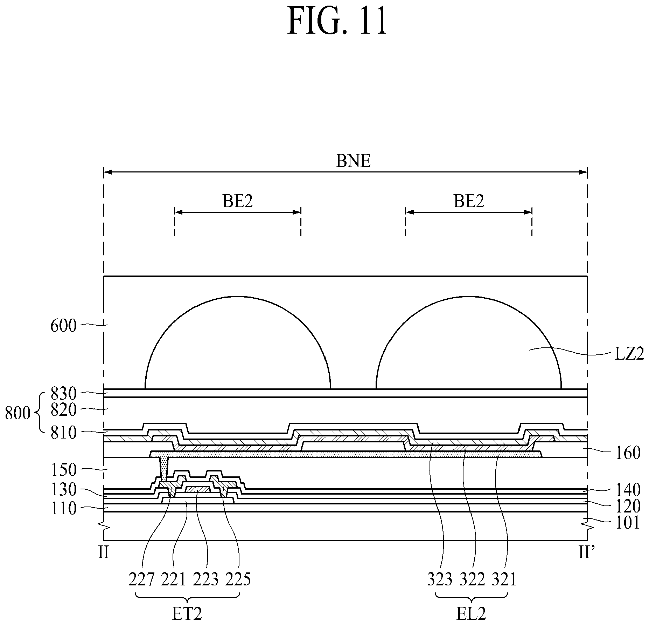

FIG. 9 is a plan view illustrating a pixel structure of the display panel according to one embodiment of the present disclosure, FIG. 10 is a cross-sectional view of the first lens region along I-I' of FIG. 9, and FIG. 11 is a cross-sectional view of the second lens region along II-II' of FIG. 9.

Referring to FIG. 9, the pixel area PA or pixel according to one embodiment of the present disclosure may include a blue B subpixel area BPA emitting blue light, a red R subpixel area RPA emitting red light, and a green G subpixel area GPA emitting green light. The R, G, and B subpixel areas RPA, GPA, and BPA may be represented by a first subpixel, a second subpixel, and a third subpixel, respectively.

The B subpixel area BPA may include a first lens region BWE including a first light emitting region BE1 of a first light emitting element EL1 and a first lens LZ1 disposed to overlap with the first light emitting region BE1, and a second lens region BNE including a second lens LZ2 overlapped with a second light emitting region BE2 of a second light emitting element EL2.

The R subpixel area RPA may include a first lens region RWE including a first light emitting region RE1 of the first light emitting element EL1 and a first lens LZ1 disposed to overlap with the first light emitting region RE1, and a second lens region RNE including a second light emitting region RE2 of the second light emitting element EL2 and a second lens LZ2 overlapped with the second light emitting region RE2.

The G subpixel area GPA may include a first lens region GWE including a first light emitting region GE1 of the first light emitting element EL1 and a first lens LZ1 disposed to overlap with the first light emitting region GE1, and a second lens region GNE including a second light emitting region GE2 of the second light emitting element EL2 and a second lens LZ2 overlapped with the second light emitting region GE2.

As described above with reference to FIGs. 5A and 5B, the first lens LZ1 and the second lens LZ2 may control the viewing angle to be different in the horizontal direction X and may control the viewing angle to be same in the vertical direction Y.

Each of the first lens regions BWE, RWE, and GWE of the pixel area PA may include one first light emitting region BE1, RE1, and GE1, and one first lens LZ1. Each of the second lens regions BNE, RNE, and GNE of the pixel area PA may include the plurality of second light emitting regions BE2, RE2, and GE2, and the plurality of second lenses LZ2.

Each of the first light emitting regions BE1, RE1, and GE1 included in the first lens region BWE, RWE, and GWE of each pixel area PA may have the same shape as the bottom surface of the first lens LZ1. The size of the first lens LZ1 is larger than the size of each of the first light emitting regions BE1, RE1, and GE1 so that it is possible to improve the emission efficiency of light generated in each of the first light emitting regions BE1, RE1, and GE1.

Each of the second light emitting regions BE2, RE2, and GE2 included in the second lens region BNE, RNE, and GNE of each pixel area PA may have the same shape as the bottom surface of the second lens LZ2. The size of the second lens LZ2 is larger than the size of each of the second light emitting regions BE2, RE2, and GE2 so that it is possible to improve the emission efficiency of light generated in each of the second light emitting regions BE2, RE2, and GE2.

According to one embodiment of the present disclosure, each of the second light emitting regions BE2, RE2, and GE2 included in the second lens region BNE, RNE, and GNE of each pixel area PA may have the same area, and the number of second light emitting regions BE2, RE2, and GE2 may be different for each subpixel area RPA, GPA, and BPA. For example, the number of second light emitting regions BE2 arranged in the second lens region BNE of the B subpixel area BPA may be greater than the number of second light emitting regions GE2 arranged in the second lens region GNE of the G subpixel area GPA and may be greater than the number of second light emitting regions RE2 arranged in the second lens region RNE of the R subpixel area RPA. The number of second light emitting regions GE2 arranged in the second lens region GNE of the G subpixel area GPA may be greater than the number of second light emitting regions RE2 disposed in the second lens region RNE of the R subpixel area RPA. Accordingly, the efficiency deviation of the second R, G, and B light emitting elements in each pixel area PA may be supplemented by the number of second light emitting regions BE2, RE2, and GE2 arranged in the second lens region BNE, RNE, and GNE of each pixel area PA.

According to one embodiment of the present disclosure, the sizes of the first light emitting regions BE1, RE1, and GE1 may be different for each subpixel area RPA, GPA, and BPA. For example, the size of the first light emitting region BE1 of the B subpixel area BPA may be greater than the size of the first light emitting region GE1 of the G subpixel area and may be greater than the size of the first light emitting region RE1 of the R subpixel area RPA. The size of the first light emitting region GE1 of the G subpixel area GPA may be greater than the size of the first light emitting region RE1 of the R subpixel area RPA. Accordingly, the efficiency deviation of the first R, G, and B light emitting elements in each pixel area PA may be supplemented by the size of the first light emitting regions BE1, RE1, and GE1 arranged in the first lens region BWE, RWE, and GWE of each pixel area PA.

The display panel 100 according to one embodiment of the present disclosure comprises a circuit element layer including a substrate 101 and transistors ET1 and ET2 arranged on the substrate 101 as shown in FIGs. 10 and 11, a light emitting element layer including light emitting elements EL1 and EL2 disposed on the circuit element layer, an encapsulation layer 800 disposed on the light emitting element layer, and a lens layer including lenses LZ1 and LZ2 disposed on the encapsulation layer 800. The display panel 100 according to one embodiment of the present disclosure may further include a touch sensor layer (not shown) disposed between the encapsulation layer 800 and the lens layer. The display panel 100 according to one embodiment of the present disclosure may further include a color filter layer (not shown) including a black matrix and a color filter disposed between the touch sensor layer and the lens layer.

FIGs. 10 and 11 illustrate a cross-sectional structure of B subpixel area BPA among R, G, and B subpixel areas RPA, GPA, and BPA in the display panel according to one embodiment of the present disclosure. The R, G, and B subpixel areas RPA, GPA, and BPA may have the same cross-sectional structure.

Each subpixel area BPA of the display panel according to one embodiment of the present disclosure may include the first lens region BWE shown in FIG. 10 and the second lens region BNE shown in FIG. 11.

Referring to FIG. 10, the first lens region BWE of the subpixel area BPA may include a first light emitting control transistor ET1 of a pixel circuit, a first light emitting element EL1 connected to the first light emitting control transistor ET1, and a first lens LZ1 disposed to overlap the first light emitting region BE1 on the first light emitting element EL1.

Referring to FIG. 11, the second lens region BNE of the subpixel area BPA may include a second light emitting control transistor ET2 of the pixel circuit, a second light emitting element EL2 connected to the second light emitting control transistor ET2, and a plurality of second lenses LZ2 disposed to overlap the plurality of second light emitting regions BE2 on the second light emitting element EL2. The second light emitting element EL2 may be described as a plurality of second light emitting elements EL2, each corresponding to a respective second lens LZ2 and to a respective second light emitting region BE2.

The circuit element layer disposed on the substrate 101 in the display panel according to one embodiment of the present disclosure may include a plurality of insulating layers stacked on the substrate 101. For example, the plurality of insulating layers may include a buffer layer 110, a gate insulating layer 120, an insulating interlayer 130, a protection layer 140, and a planarization layer 150.

The substrate 101 may comprise an insulating material such as glass or plastic. The plastic substrate may be formed of a flexible material. For example, the substrate 101 may include at least one organic insulating material among acrylic resin, epoxy-based resin, siloxane-based resin, polyimide-based resin, and polyamide-based resin.

The buffer layer 110 may have a single-layered or multi-layered structure including an inorganic insulating material such as silicon oxide SiOx, silicon nitride SiNx, and aluminum oxide Al₂O₃. The buffer layer 110 may prevent impurities such as hydrogen from flowing into semiconductor layers 211 and 221 through the substrate 101.

The transistors ET1 and ET2 may be disposed on the buffer layer 110.

The first light emitting control transistor ET1 includes the semiconductor layer 211, a gate electrode 213, a source electrode 215, and a drain electrode 217 disposed on the buffer layer 110. The second light emitting control transistor ET2 includes the semiconductor layer 221, a gate electrode 223, a source electrode 225, and a drain electrode 227 disposed on the buffer layer 110. The gate insulating layer 120 is disposed between the semiconductor layer 211 and the gate electrode 213 and between the semiconductor layer 221 and the gate electrode 223. The insulating interlayer 130 is disposed between the gate electrode 213 and the source and drain electrodes 215, 217, and between the gate electrode 223 and the source and drain electrodes 225, 227. The source electrode 215 and the drain electrode 217 of the first light emitting control transistor ET1 may be connected to a source region and a drain region of the semiconductor layer 211, respectively, through contact holes passing through the insulating interlayer 130 and the gate insulating layer 120. The source electrode 225 and the drain electrode 227 of the second light emitting control transistor ET2 may be connected to the source region and the drain region of the semiconductor layer 221, respectively, through contact holes passing through the insulating interlayer 130 and the gate insulating layer 120.

The semiconductor layers 211 and 221 may include polycrystalline silicon or may include an oxidation semiconductor material. The semiconductor layers 211 and 221 may include low temperature polysilicon LPTS. The semiconductor layers 211 and 221 may include at least one oxide semiconductor material selected from the group consisting of IZO(InZnO)-based, IGO(InGaO)-based, ITO(InSnO)-based, IGZO(InGaZnO)-based, IGZTO(InGaZnSnO)-based, GZTO(GaZnSnO)-based, GZO(GaZnO)-based, and ITZO(InSnZnO)-based oxide semiconductor materials. A light shielding layer (not shown) may be further disposed under the semiconductor layers 211 and 221.

The gate insulating layer 120 may include an inorganic insulating material such as silicon oxide SiOx and/or silicon nitride SiNx. The gate insulating layer 120 may include a material having a high dielectric constant. For example, the gate insulating layer 120 may include a high-K material such as hafnium oxide HfO. The gate insulation layer 120 may have a multi-layered structure.

Gate lines (not shown) connected to the gate electrodes 213 and 223 may be provided on the gate insulating layer 120.

The insulating interlayer 130 may include an inorganic insulating material such as silicon oxide SiOx and/or silicon nitride SiNx. The insulating interlayer 130 may have a multi-layered structure.

Also, data lines (not shown) and power lines (not shown) connected to the source electrodes 215 and 225 or the drain electrodes 217 and 227 may be provided on the insulating interlayer 130.

The protection layer 140 and the planarization layer 150 may be stacked on the first and second light emitting control transistors ET1 and ET2. The protection layer 140 may include an inorganic insulating material such as silicon oxide SiOx and/or silicon nitride SiNx. The planarization layer 150 may include an organic insulating material which is different from that of the protection layer 140 and may provide a flat surface.

The light emitting element layer including the first light emitting element EL1 and the second light emitting element EL2 may be disposed on the planarization layer 150.

The first light emitting element EL1 includes a first electrode 311 disposed on the planarization layer 150, a light emitting layer 312 disposed on the first electrode 311, and a second electrode 313 disposed on the light emitting layer 312. The second light emitting element EL2 includes a first electrode 321 disposed on the planarization layer 150, a light emitting layer 322 disposed on the first electrode 321, and a second electrode 323 disposed on the light emitting layer 322. The first light emitting element EL1 and the second light emitting element EL2 disposed in each subpixel area BPA may emit light of the same color.

The first electrode 311 of the first light emitting element EL1 may be connected to any one of the source electrode 215 and the drain electrode 217 of the first light emitting control transistor ET1 through a contact hole passing through the planarization layer 150 and the protection layer 140. The first electrode 321 of the second light emitting element EL2 may be connected to any one of the source electrode 225 and the drain electrode 227 of the second light emitting control transistor ET2 through a contact hole passing through the planarization layer 150 and the protection layer 140.

The first electrodes 311 and 321 may include a conductive material having high reflectivity. The first electrodes 311 and 321 may include metal such as aluminum Al, silver Ag, titanium Ti, and/or a silver-palladium-copper APC alloy. The first electrodes 311 and 321 may further include a transparent conductive material such as indium tin oxide ITO or indium zinc oxide IZO. For example, the first electrodes 311 and 321 may have a multilayer structure Ti/AI/Ti of titanium Ti and aluminum Al, a multilayer structure ITO/AI/ITO of ITO and aluminum Al, or a multilayer structure ITO/APC/ITO of ITO and APC.

The light emitting layers 312 and 322 may include an emission material layer EML including a light emitting material. The light emitting material may include an organic material, an inorganic material, or a hybrid material. The light emitting layer 312 of the first light emitting element EL1 and the light emitting layer 322 of the second light emitting element EL2 may be spaced apart from each other. Accordingly, it is possible to prevent a light emission caused by a leakage current.

The light emitting layers 312 and 322 may have a multi-layered structure. For example, the light emitting layers 312 and 322 may further include at least one of a hole injection layer HIL, a hole transport layer HTL, an electron transport layer ETL, and an electron injection layer EIL.

The second electrodes 313 and 323 may include a conductive material capable of transmitting light therethrough. The second electrodes 313 and 323 may include a transparent conductive material such as ITO or IZO. The second electrodes 313 and 323 may include aluminum Al, magnesium Mg, silver Ag, or an alloy thereof, and may have a thin thickness capable of transmitting light. Accordingly, the light generated in each of the light emitting layers 312 and 322 may be emitted through each of the second electrodes 313 and 323.

The first electrode 311 of the first light emitting element EL1 is spaced apart from the first electrode 321 of the second light emitting element EL2, and a bank insulating layer 160 may be positioned between the first electrodes 311 and 321. The bank insulating layer 160 may cover the edge of each of the first electrodes 311 and 321. The bank insulating layer 160 may include an organic insulating material. The bank insulating layer 160 may include an organic material which is different from that of the planarization layer 150 and may have a single-layered or double-layered structure.

The bank insulating layer 160 may be configured to include an opening through which the first electrode 311 is exposed, to thereby define the first light emitting region BE1. The light emitting layer 312 and the second electrode 313 of the first light emitting element EL1 may be stacked on the first electrode 311 exposed by the opening of the bank insulating layer 160.

The bank insulating layer 160 may be configured to include an opening through which the first electrode 321 of the second light emitting element EL2 is exposed, to thereby define the second light emitting region BE2. According to one embodiment, the bank insulating layer 160 includes a plurality of openings through which the first electrode 321 of the second light emitting element EL2 is exposed, to thereby define the plurality of second light emitting regions BE2. The light emitting layer 322 and the second electrode 323 of the second light emitting element EL2 may be stacked on the first electrode 321 exposed by the opening(s) of the bank insulating layer 160. The light emitting layer 322 and the second electrode 323 of the second light emitting element EL2 may overlap the first electrode 321. In the second lens region BNE, even though the plurality of second light emitting regions BE2 are separately spaced apart from each other by the bank insulating layer 160, i.e. with the bank insulating layer 160 interposed therebetween, the plurality of second light emitting regions BE2 share the first electrode 321 of the second light emitting element EL2, share the light emitting layer 322 of the second light emitting element EL2, and share the second electrode 323 of the second light emitting element EL2. Accordingly, the luminous efficiency of the second light emitting regions BE2 may be improved. Herein, the size of the second light emitting region BE2 may be smaller than the size of the first light emitting region BE1.

The second electrode 313 of the first light emitting element EL1 may be a common electrode electrically connected to the second electrode 323 of the second light emitting element EL2.

The encapsulation layer 800 may be disposed on the light emitting element layer including the first light emitting element EL1 and the second light emitting element EL2 of each subpixel area BPA. The encapsulation layer 800 may prevent the light emitting elements EL1 and EL2 from being damaged by moisture and impact from the outside. The encapsulation layer 800 may have a multi-layered structure. For example, the encapsulation layer 800 may include a first encapsulation layer 810, a second encapsulation layer 820, and a third encapsulation layer 830 which are sequentially stacked, but is not limited thereto. The first encapsulation layer 810, the second encapsulation layer 820, and the third encapsulation layer 830 may each include a respective insulating material. The second encapsulation layer 820 may include a material different from that of the first encapsulation layer 810 and the third encapsulation layer 830. For example, the first encapsulation layer 810 and the third encapsulation layer 830 may be inorganic encapsulation layers including an inorganic insulating material, and the second encapsulation layer 820 may include an organic encapsulation layer including an organic insulating material. Accordingly, it is possible to prevent the light emitting elements EL1 and EL2 of the display apparatus from being damaged by moisture and impact from the outside.

The lens layer including the first lens LZ1 and the second lens LZ2 may be disposed on the encapsulation layer 800 of each subpixel area BPA.

The first lens LZ1 is disposed on the first light emitting region BE1 of the first light emitting element 310 in the first lens region BWE so that the traveling path of the light generated in the first light emitting region BE1 is not limited in the left and right direction, that is, it is controlled to provide the wide viewing angle. For example, the first lens LZ1 may control the viewing angle to provide the wide viewing angle since the traveling path of the light emitted from the first light emitting region BE1 of the first light emitting element EL1 is not limited within a specific angle in the left-right direction, and may control the viewing angle to provide the narrow viewing angle by limiting the traveling path of the light within a specific angle in the up-and-down direction.

The second lens LZ2 is disposed on the second light emitting region BE2 of the second light emitting element EL2 in the second lens region BNE, and the second lens LZ2 may control the viewing angle to provide the narrow viewing angle by limiting the traveling path of the light generated in the second light emitting region BE2 in the left and right direction. For example, the second lens LZ2 may control the viewing angle to provide the narrow viewing angle by limiting the traveling path of light emitted from the second light emitting region BE2 of the second light emitting element EL2 in the left and right direction, and may control the viewing angle to provide the narrow viewing angle by limiting the traveling path of the light within a specific angle in the up-and-down direction.

A lens protection layer 600 may be located on the first lens LZ1 and the second lens LZ2 of each subpixel area BPA. The lens protection layer 600 may include an organic insulating material. A refractive index of the lens protection layer 600 may be smaller than a refractive index of the first lens LZ1 and a refractive index of the second lens LZ2. Accordingly, the light passing through the first lens LZ1 and the second lens LZ2 may not be reflected toward the substrate 101 due to the difference in refractive index with the lens protection layer 600.

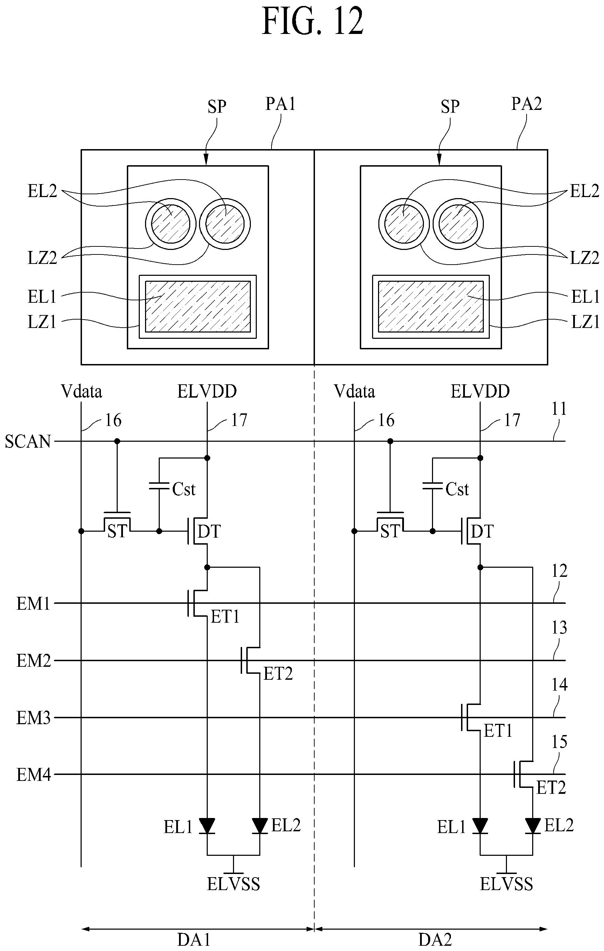

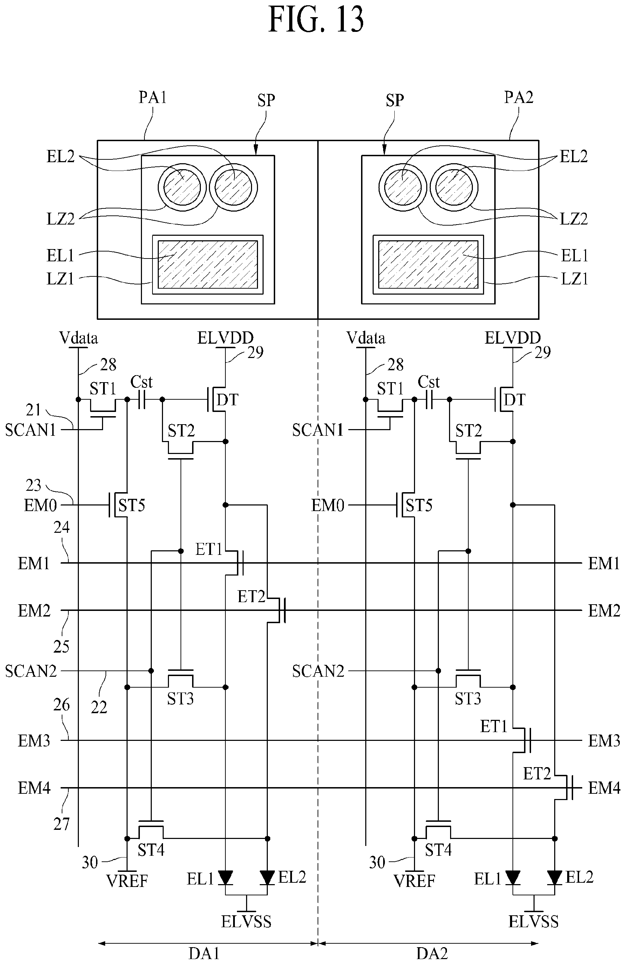

FIGs. 12 and 13 are equivalent circuit diagrams illustrating subpixel configurations of first and second areas in the display panel according to one embodiment of the present disclosure.

FIGs. 12 and 13 illustrate a configuration of each subpixel SP in the first and second pixel areas PA1 and PA2 included in the first and second areas DA1 and DA2 of the display panel according to one embodiment of the present disclosure. According to one embodiment of the present disclosure, the display apparatus may independently control the viewing angle of the first and second areas DA1 and DA2 of the display panel. According to one embodiment of the present disclosure, the display apparatus may differently control the viewing angle of the first and second areas DA1 and DA2 of the display panel and may equally control/control in the same way the viewing angle of the first and second areas DA1 and DA2 of the display panel.

Referring to FIGs. 12 and 13, each of the subpixels SP disposed on the (n)th pixel row line may include a pixel circuit including a plurality of transistors and first and second light emitting elements EL1 and EL2, and first and second lenses LZ1 and LZ2 disposed on the first and second light emitting elements EL1 and EL2, respectively.

The pixel circuit of the subpixel SP shown in FIG. 12 may include a switching transistor ST, a driving transistor DT, a storage capacitor Cst, first and second light emitting control transistors ET1 and ET2, and first and second light emitting elements EL1 and EL2, but is not limited thereto.

The pixel circuit of the subpixel SP shown in FIG. 13 may include five switching transistors ST1-ST5, a driving transistor DT, a storage capacitor Cst, first and second light emitting control transistors ET1 and ET2, and first and second light emitting elements EL1 and EL2.

Referring to FIGs. 12 and 13, in each subpixel SP, the first light emitting element EL1 may be driven by the first light emitting control transistor ET1 and/or the second light emitting element EL2 may be driven by the second light emitting control transistor ET2. The first lens LZ1 disposed in the light traveling direction of the first light emitting element EL1 may control the viewing angle in the left and right direction to provide the wide viewing angle. The second lens LZ2 disposed in the light traveling direction of the second light emitting element EL2 may control the viewing angle in the left and right directions to provide the narrow viewing angle.

Each of the transistors of each subpixel SP includes a gate electrode, a source electrode, and a drain electrode. Since the source electrode and the drain electrode may be changed according to a voltage and a current direction applied to the gate electrode without being fixed, any one of the source and drain electrodes may be represented as a first electrode, and the other may be represented as a second electrode. The transistors of each subpixel SP may use at least one of polysilicon semiconductor, amorphous silicon semiconductor, and oxide semiconductor. The transistors may be P-type or N-type, or P-type and N-type may be used interchangeably.

Each of the light emitting elements EL1 and EL2 may include an anode individually connected to the light emitting control transistors ET1 and ET2, a cathode supplied with a second power voltage (low-potential power voltage) ELVSS, and a light emitting layer between the anode and the cathode. The anode may be independently provided for each light emitting element. However, the cathode may be a common electrode shared by the entire light emitting elements. When a driving current is supplied from the driving transistor DT through each of the light emitting control transistors ET1 and ET2, electrons from the cathode are injected into the light emitting layer, holes from the anode are injected into the organic light emitting layer, and fluorescent or phosphorescent materials emit light through the bond of electrons and holes in the light emitting layer, whereby each of the light emitting elements EL1 and EL2 may generate light of luminance proportional to a current value of the driving current.

The first light emitting control transistor ET1 and the second light emitting control transistor ET2 may be controlled by the different light emitting control signals. The subpixel SP of the first area DA1 and the subpixel SP of the second area DA2 may be included in the same pixel row line, wherein the subpixel SP of the first area DA1 and the subpixel SP of the second area DA2 may differently control the viewing angle by the different light emitting control signals or may equally control the viewing angle, i.e. may control the viewing angle to be the same.

The first light emitting control transistor ET1 of the subpixel SP in the first area DA1 and the first light emitting control transistor ET1 of the subpixel SP in the second area DA2 are included in the same pixel row line and may be selectively turned-on or turned-off by the different light emitting control signals. The second light emitting control transistor ET2 of the subpixel SP in the first area DA1 and the second light emitting control transistor ET2 of the subpixel SP in the second area DA2 are included in the same pixel row line and may be selectively turned-on or turned-off by the different light emitting control signals.

For example, when the first light emitting control transistor ET1 is turned-on by the first light emitting control signal EM1, the first light emitting element EL1 is driven so that the subpixel SP of the first area DA1 may be controlled to provide the wide viewing angle through the first lens LZ1. When the second light emitting control transistor ET2 is turned-on by the second light emitting control signal EM2, the second light emitting element EL2 is driven so that the subpixel SP of the first area DA1 may be controlled to provide the narrow viewing angle through the second lens LZ2.

When the first light emitting control transistor ET1 is turned-on by the third light emitting control signal EM3, the first light emitting element EL1 is driven so that the subpixel SP of the second area DA2 may be controlled to provide the wide viewing angle through the first lens LZ1. When the second light emitting control transistor ET2 is turned-on by the fourth light emitting control signal EM4, the second light emitting element EL2 is driven so that the subpixel SP of the second area DA2 may be controlled to provide the narrow viewing angle through the second lens LZ2.

Referring to FIG. 12, in the case of the subpixel SP of the first area DA1, the first light emitting control transistor ET1 is controlled by the first light emitting control signal EM1 of the first gate line 12 among the plurality of gate lines 12 to 15 disposed in the (n)th pixel row line (herein, 'n' is a natural number), and the second light emitting control transistor ET2 may be controlled by the second light emitting control signal EM2 of the second gate line 13. In the subpixel SP of the second area DA2, the first light emitting control transistor ET1 is controlled by the third light emitting control signal EM3 of the third gate line 14, and the second light emitting control transistor ET2 may be controlled by the fourth light emitting control signal EM4 of the fourth gate line 15.

Referring to FIG. 13, in the case of the subpixel SP of the first area DA1, the first light emitting control transistor ET1 is controlled by the first light emitting control signal EM1 of the first gate line 24 among the plurality of gate lines 24 to 27 disposed in the (n)th pixel row line, and the second light emitting control transistor ET2 may be controlled by the second light emitting control signal EM2 of the second gate line 25. In the subpixel SP of the second area DA2, the first light emitting control transistor ET1 is controlled by the third light emitting control signal EM3 of the third gate line 26, and the second light emitting control transistor ET2 may be controlled by the fourth light emitting control signal EM4 of the fourth gate line 27.

Referring to FIG. 12, the switching transistor ST may supply the data voltage Vdata supplied to the data line 16 to the gate electrode of the driving transistor DT in response to the scan signal SCAN supplied to the fifth gate line 11 disposed in the (n)th pixel row line. The scan signal SCAN may be supplied from the scan driver SD (See FIG. 1).

The storage capacitor Cst is connected between the gate electrode of the driving transistor DT and the first electrode, to thereby charge or store the driving voltage Vgs corresponding to the data voltage Vdata. The storage capacitor Cst may hold the charged driving voltage Vgs during a period in which the switching transistor ST is turned-off, and may supply the held driving voltage Vgs to the driving transistor DT. The data voltage Vdata may be supplied from the data driver DD (See FIG. 1).

A first electrode of the driving transistor DT may be connected to a power line 17 for supplying a first power voltage ELVDD (high-potential power voltage). The first power voltage ELVDD may be supplied from a power management circuit (not shown). A second electrode of the driving transistor DT may be commonly connected to the first electrodes of the first and second light emitting control transistors ET1 and ET2. The driving transistor DT may be connected to the first light emitting element EL1 through the first light emitting control transistor ET1 and/or may be connected to the second light emitting element EL2 through the second light emitting control transistor ET2. The driving transistor DT controls the driving current Ids according to the driving voltage Vgs of the storage capacitor Cst so that it is possible to control the emission intensity of the first light emitting element EL1 and/or the second light emitting element EL2 through the first light emitting control transistor ET1 or the second light emitting control transistor ET2 respectively.

Referring to FIG. 13, the first switching transistor ST1 may supply the data voltage Vdata supplied to the data line 28 to the first electrode of the storage capacitor Cst in response to a first scan signal SCAN1 supplied to the fifth gate line 21 disposed in the (n)th pixel row line. The scan signal SCAN1 may be supplied from the scan driver SD (See FIG. 1).

The second to fourth switching transistors ST 2 to ST 4 may be turned-on or turned-off in response to a second scan signal SCAN2 supplied to the sixth gate line 22 disposed in the (n)th pixel row line. The scan signal SCAN2 may be supplied from the scan driver SD (FIG. 1).

The second switching transistor ST2 connects the gate electrode of the driving transistor DT and the second electrode (or drain electrode) to each other in response to the second scan signal SCAN2, thereby connecting the driving transistor DT to the diode structure. The second switching transistor ST2 may charge the threshold voltage Vth of the driving transistor DT in the storage capacitor Cst, to thereby compensate for the storage capacitor Cst. The second switching transistor ST2 may supply the first power voltage ELVDD supplied through the driving transistor DT from a power line 29 to the second electrode of the storage capacitor Cst connected to the gate electrode of the driving transistor DT.

The third switching transistor ST3 may supply an initialization voltage Vref (or reference voltage) supplied through an initialization voltage line 30 to the anode of the first light emitting element EL1 in response to the second scan signal SCAN2.

The fourth switching transistor ST4 may supply the initialization voltage Vref (or reference voltage) supplied through the initialization voltage line 30 to the anode of the second light emitting element EL2 in response to the second scan signal SCAN2.

The fifth switching transistor ST5 may supply the initialization voltage Vref (or reference voltage) supplied through the initialization voltage line 30 to the first electrode of the storage capacitor Cst in response to the light emitting control signal EM0 supplied to the seventh gate line 23 disposed in the (n)th pixel row line. The light emitting control signal EM0 may be supplied from the emission control driver EMD (see FIG. 1).

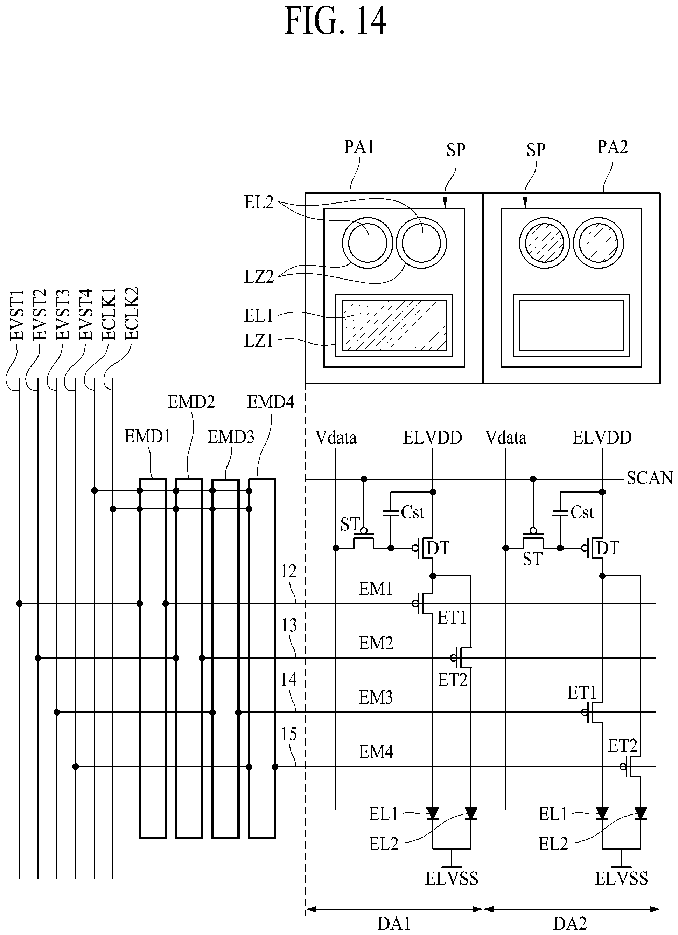

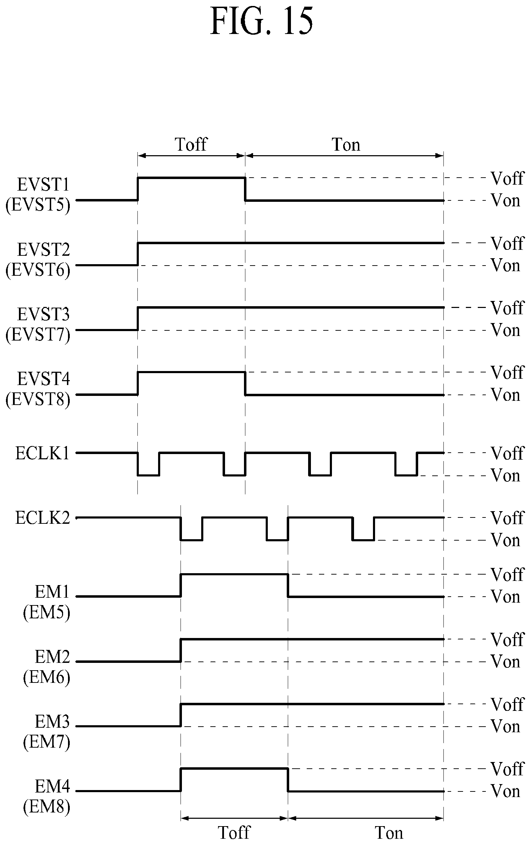

FIG. 14 schematically illustrates the first and second areas and emission control drivers of the display panel according to one embodiment of the present disclosure, and FIG. 15 illustrates input/output waveforms of the emission control drivers according to one embodiment of the present disclosure.

Referring to FIG. 14, the display apparatus according to one embodiment of the present disclosure may include the plurality of emission control drivers EMD1∼EMD4 for individually supplying the plurality of light emitting control signals to the plurality of gate lines 12 to 15 arranged in each pixel row line. The plurality of emission control drivers EMD-EMD4 may be disposed in at least one of the first and second bezel areas BZ1 and BZ2 of the display panel 100 (See FIG. 1). The subpixel SP may use the pixel circuit described with reference to FIG. 12.

The first emission control driver EMD1 may include a plurality of stages configured to individually output the plurality of first light emitting control signals EM1 to the plurality of first gate lines 12 respectively disposed in the plurality of pixel row lines. The first emission control driver EMD1 is driven by receiving a first start signal EVST1, and each stage may supply the first light emitting control signal EM1 to the first light emitting control transistor ET1 of the subpixel SP of the first area DA1 through the first gate line 12 of each pixel row line.

The second emission control driver EMD2 may include a plurality of stages configured to individually output the plurality of second light emitting control signals EM2 to the plurality of second gate lines 13 respectively disposed in the plurality of pixel row lines. The second emission control driver EMD2 is driven by receiving a second start signal EVST2, and each stage may supply the second light emitting control signal EM2 to the second light emitting control transistor ET2 of the subpixel SP of the first area DA1 through the second gate line 13 of each pixel row line.

The third emission control driver EMD3 may include a plurality of stages configured to individually output the plurality of third light emitting control signals EM3 to the plurality of third gate lines 14 respectively disposed in the plurality of pixel row lines. The third emission control driver EMD3 is driven by receiving a third start signal EVST3, and each stage may supply the third light emitting control signal EM3 to the first light emitting control transistor ET1 of the subpixel SP of the second area DA2 through the third gate line 14 of each pixel row line.

The fourth emission control driver EMD4 may include a plurality of stages configured to individually output the plurality of fourth light emitting control signals EM4 to the plurality of fourth gate lines 15 respectively disposed in the plurality of pixel row lines. The fourth emission control driver EMD4 is driven by receiving a fourth start signal EVST4, and each stage may supply the fourth light emitting control signal EM4 to the second light emitting control transistor ET2 of the subpixel SP of the second area DA2 through the fourth gate line 15 of each pixel row line.

Referring to FIGs. 14 and 15, the first to fourth emission control drivers EMD1∼EMD4 receive first and second clock signals ECLK1 and ECLK2 in common, and the first to fourth emission control drivers EMD1∼EMD4 may be individually supplied with the first to fourth start signals EVST1 to EVST4, and may be individually driven so that it is possible to individually output the first to fourth light emitting control signals EM1 to EM4 to the first to fourth gate lines 12 to 15 of each pixel row line. The clock signals ECLK1 and ECLK2 and the start signals EVST1∼EVST4 may be supplied from the timing controller TCON or the level shifter LS shown in FIG. 1.

Referring to FIG. 15, input/output signals of the emission control drivers EMD1∼EMD4 may have a gate-off voltage Voff for turning-off the emission control transistors ET1 and ET2 and a gate-on voltage Von for turning-on the emission control transistors ET1 and ET2.

The clock signals ECLK1 and ECLK2 may periodically include a negative pulse which swings the gate-off voltage Voff and the gate-on voltage Von and may have different phases from each other.

Among the start signals EVST1-EVST4, the signals (for example, EVST1 and EVST4) activated for the viewing angle control may have an off-period (deactivation) Toff and an on-period (activation) period Ton (Ton>Toff) during an active period of each frame, and the deactivated signals (for example, EVST2 and EVST3) may be in an off-period (deactivated) during the active period of each frame.

The emission control drivers (for example, EMD1 and EMD4) driven (activated) by the activated start signals EVST1 and EVST4 may output the activated light emitting control signals (for example, EM1 and EM4). The activated light emitting control signals EM1 and EM4 may have an off-period Toff and an on-period Ton (Ton>Toff) during the active period of each frame. The emission control drivers (for example, EMD2 and EMD3) supplied with the deactivated start signals EVST2 and EVST3 may output the deactivated light emitting control signals (for example, EM2 and EM3).

For example, in the display apparatus according to one embodiment of the present disclosure, the activated start signals EVST1 and EVST4 are respectively supplied to the first and fourth emission control drivers EMD1 and EMD4, and the deactivated start signals EVST2 and EVST3 are respectively supplied to the second and third emission control drivers EMD2 and EMD3, whereby the first area DA1 is driven in the wide viewing angle mode and the second area DA is driven in the narrow viewing angle mode.

Accordingly, the first emission control driver EMD1 may output the first light emitting control signal EM1 activated through the first gate line 12, and the fourth emission control driver EMD4 may output the fourth light emitting control signal EM4 activated through the fourth gate line 15. The second emission control driver EMD2 may output the second light emitting control signal EM2 deactivated through the second gate line 13, and the third emission control driver EMD3 may output the deactivated third light emitting control signal EM3 through the third gate line 14.

Accordingly, in each subpixel SP of the first area DA1, the first light emitting element EL1 is driven through the first light emitting control transistor ET1, whereby the viewing angle may be controlled to be the wide viewing angle through the first lens LZ1. In each subpixel SP of the second area DA2, the second light emitting element EL2 is driven through the second light emitting control transistor ET2, whereby the viewing angle may be controlled to be the narrow viewing angle through the second lenses LZ2.

According to one embodiment of the present disclosure, when the second area DA2 is driven in the wide viewing angle mode, the display apparatus may supply the activated third start signal EVST3 to the third emission control driver EMD3 and may supply the deactivated fourth start signal EVST4 to the fourth emission control driver EMD4. Also, the third light emitting control signal EM3 activated through the third gate line 14 may be output from the third emission control driver EMD3, and the fourth light emitting control signal EM4 deactivated through the fourth gate line 15 may be output from the fourth emission control driver EMD4. Accordingly, in each subpixel SP of the second area DA2, the first light emitting element EL1 is driven through the first light emitting control transistor ET1, whereby the viewing angle may be controlled to be the wide viewing angle through the first lens LZ1.

According to an embodiment of the present disclosure, when the first area DA1 is driven in the narrow viewing angle mode, the display apparatus may supply the activated second start signal EVST2 to the second emission control driver EMD2, and may supply the deactivated first start signal EVST1 to the first emission control driver EMD1. The second light emitting control signal EM2 activated through the second gate line 13 may be output from the second emission control driver EMD2, and the first light emitting control signal EM1 deactivated through the first gate line 12 may be output from the first emission control driver EMD1. Accordingly, in each subpixel SP of the first area DA1, the second light emitting element EL2 is driven through the second light emitting control transistor ET2, whereby the viewing angle may be controlled to be the narrow viewing angle through the second lens LZ2.

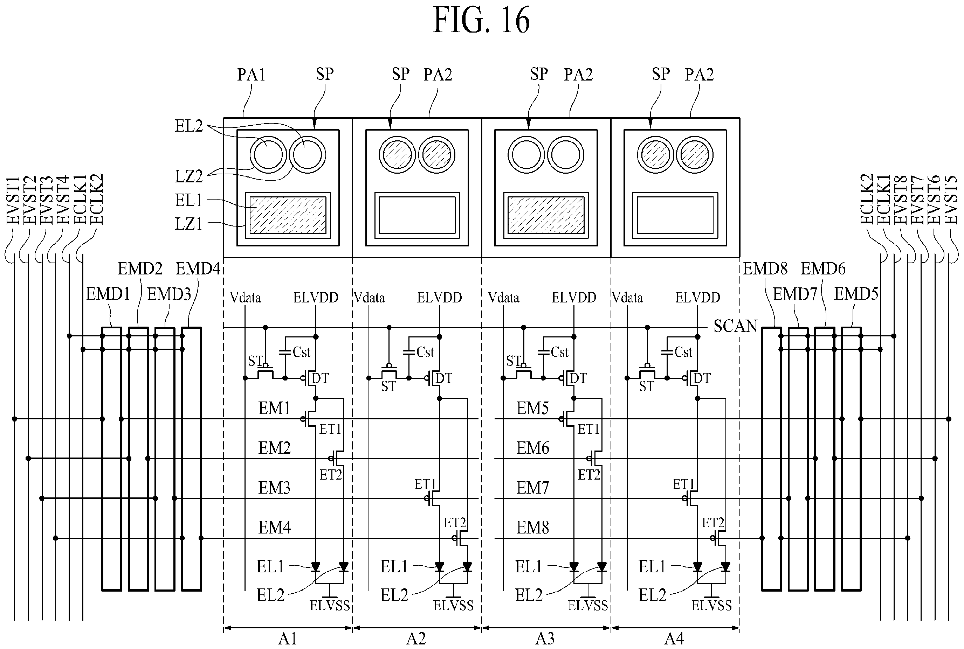

FIG. 16 schematically illustrates first to fourth areas and emission control drivers of a display panel according to one embodiment of the present disclosure.

According to one embodiment of the present disclosure, a display panel is divided into four areas A1∼A4 to independently control a viewing angle in the different areas. Each of the first to fourth areas A1∼A4 may control a viewing angle to provide a wide viewing angle mode or a narrow viewing angle mode. A subpixel SP may use the pixel circuit described with reference to FIG. 12.

According to one embodiment of the present disclosure, a display apparatus may comprise first to fourth emission control drivers EMD1∼EMD4 for driving the first and second areas A1 and A2, and fifth to eighth emission control drivers EMD5∼EMD8 for driving the third and fourth areas A3 and A4. Herein, gate lines of the first and second areas A1 and A2 and gate lines of the third and fourth areas A3 and A4 may be divided into left and right sides. The first to fourth emission control drivers EMD1∼EMD4 may be disposed in the first bezel area BZ1 (See FIG. 1) of the display panel 100 (See FIG. 1), and the fifth to eighth emission control drivers EMD5∼EMD8 may be disposed in the second bezel area BZ2 (See FIG. 1).

The emission control drivers EMD1∼EMD8 may commonly receive first and second clock signals ECLK1 and ECLK2 and may individually receive first to eighth start signals EVST1∼EVST8 and may be driven respectively, whereby the emission control drivers EMD1∼EMD8 may individually output first to eighth light emitting control signals EM1∼EM8.

For example, the emission control drivers EMD1∼EMD8 may be commonly supplied with the first and second clock signals ECLK1 and ECLK2 illustrated in FIG. 15 and may be individually/respectively supplied with the first to eighth start signals EVST1∼EVST8.

According to one embodiment of the present disclosure, the first to fourth emission control drivers EMD1∼EMD4 may be driven by receiving the first to fourth start signals EVST1-EVST4, respectively. The first emission control driver EMD1 supplies the first light emitting control signal EM1 to a first light emitting control transistor ET1 of the first area A1, the second emission control driver EMD2 supplies the second light emitting control signal EM2 to a second light emitting control transistor ET2 of the first area A1, the third emission control driver EMD3 supplies the third light emitting control signal EM3 to a first light emitting control transistor ET1 of the second area A2, and the fourth emission control driver EMD4 supplies the fourth light emitting control signal EM4 to a second light emitting control transistor ET2 of the second area A2.

The fifth to eighth emission control drivers EMD5∼EMD8 may be driven by receiving the fifth to eighth start signals EVST5∼EVST8 shown in FIG. 15, respectively. The fifth emission control driver EMD5 supplies the fifth light emitting control signal EM5 to a first light emitting control transistor ET1 of the third area A3, the sixth emission control driver EMD6 supplies the sixth light emitting control signal EM6 to a second light emitting control transistor ET2 of the third area A3, the seventh emission control driver EMD7 supplies the seventh light emitting control signal EM7 to a first light emitting control transistor ET1 of the fourth area A4, and the eighth emission control driver EMD8 supplies the eighth light emitting control signal EM8 to a second light emitting control transistor ET2 of the fourth area A4.

For example, when the first and third areas A1 and A3 are driven in a wide viewing angle mode, each of the first and fifth emission control drivers EMD1 and EMD5 may receive activated start signals EVST1 and EVST5, respectively, to thereby activate light emitting control signals EM1 and EM5, respectively. Thus, as the first light emitting control transistor ET1 is driven, the first and third areas A1 and A3 may be controlled to provide the wide viewing angle through the first lens LZ1. The second and sixth emission control drivers EMD2 and EMD6 may receive deactivated start signal EVST2 and EVST6, to thereby deactivate the light emitting control signals EM2 and EM6.

When the second and fourth areas A2 and A4 are driven in a narrow viewing angle mode, each of the fourth and eighth emission control drivers EMD4 and EMD8 may receive activated start signals EVST4 and EVST8, respectively, to activate the light emitting control signals EM4 and EM8, respectively. Thus, as the second light emitting control transistor ET2 is driven, the second and fourth areas A2 and A4 may be controlled to provide the narrow viewing angle through the second lens LZ2. The third and seventh emission control drivers EMD3 and EMD7 may receive deactivated start signal EVST3 and EVST7, to thereby deactivate the light emitting control signals EM3 and EM7.

According to one embodiment of the present disclosure, the display apparatus activates the first, third, fifth, and eighth light emitting control signals EM1, EM3, EM5, and EM8 through the first, third, fifth, and eighth emission control drivers EMD1, EMD3, EMD5, and EMD8, thereby controlling the viewing angle of the first to third areas A1, A2, and A3 to provide the wide viewing angle, and controlling the viewing angle of the fourth area A4 to provide the narrow viewing angle.

According to one embodiment of the present disclosure, the display apparatus activates the first, fourth, sixth, and eighth light emitting control signals EM1, EM4, EM6, and EM8 through the first, fourth, sixth, and eighth emission control drivers EMD1, EMD4, EMD6, and EMD8, thereby controlling the viewing angle of the first area A1 to provide the wide viewing angle, and controlling the viewing angle of the second to fourth areas A2, A3, and A4 to provide the narrow viewing angle.

According to one embodiment of the present disclosure, the display apparatus activates the first, third, fifth, and seventh light emitting control signals EM1, EM3, EM5, and EM7 through the first, third, fifth, and seventh emission control drivers EMD1, EMD3, EMD5, and EMD7, thereby controlling the viewing angle of the entire first to fourth areas A1∼A4 to provide the wide viewing angle.

According to one embodiment of the present disclosure, the display apparatus may control the viewing angle of the entire first to fourth areas A1∼A4 to provide the narrow viewing angle by activating the second, fourth, sixth, and eighth light emitting control signals EM2, EM4, EM6, and EM8 through the second, fourth, sixth, and eighth emission control drivers EMD2, EMD4, EMD6, and EMD8.

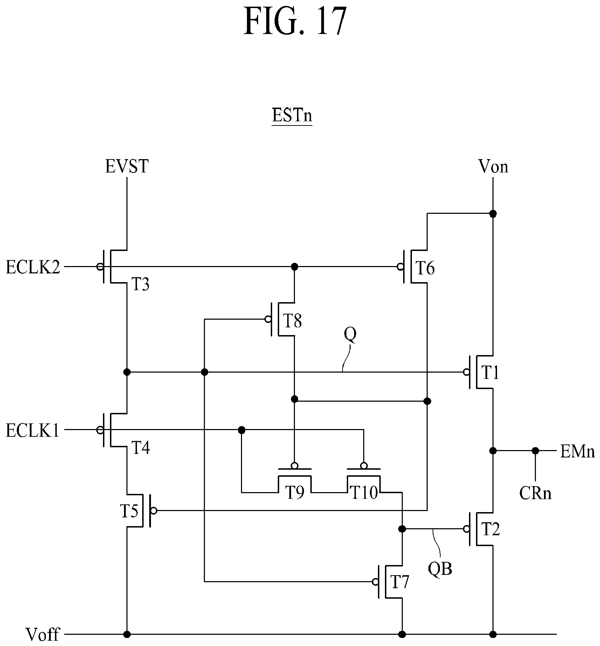

FIG. 17 is an equivalent circuit diagram illustrating a configuration of any one stage in any one emission control driver according to one embodiment of the present disclosure.

Referring to FIG. 17, a stage ESTn may be supplied with a start signal EVST, first and second clock signals ECLK1 and ECLK2, a gate-on voltage Von, and a gate-off voltage Voff. When the stage ESTn corresponds to the second one or more of a plurality of stages, the start signal EVST may be supplied with/as a previous carry signal output from the previous stage. The start signal and the previous carry signal may be expressed as an input signal.

The stage ESTn according to one embodiment of the present disclosure may comprise an output buffer including first and second transistors T1 and T2, and a node controller including third to tenth transistors T3∼T10. The plurality of transistors T1~T10 constituting the stage ESTn according to one embodiment of the present disclosure may use an LTPS transistor or oxide transistor, or the LTPS transistor and oxide transistor may be interchangeably used.

The first transistor T1 of the output buffer may output the gate-on voltage Von of first power line as the gate-on voltage Von of light emitting control signal EMn and carry signal CRn through an output line in response to the control of first control node Q. When the first control node Q is activated, the first transistor T1 may output the gate-on voltage Von to the output line.

The second transistor T2 of the output buffer may output the gate-off voltage Voff of second power line as the gate-off voltage Voff of light emitting control signal EMn and carry signal CRn through the output line in response to the control of second control node QB. When the second control node QB is activated, the second transistor T2 may output the gate-off voltage Voff to the output line.

The third transistor T3 of the node controller may output the start signal EVST of input line or the previous carry signal to the first control node Q in response to the control of second clock signal ECLK2 of a second clock line. The first control node Q may be activated by the start signal EVST or previous carry signal.

The fourth transistor T4 of the node controller may connect the first control node Q and a first electrode of the fifth transistor T5 in response to the control of first clock signal ECLK1 of a first clock line. The fifth transistor T5 of the node controller may connect a second electrode of the fourth transistor T4 and the second power line supplied with the gate-off voltage Voff in response to an output voltage of the sixth transistor T6. When the fourth and fifth transistors T4 and T5 are turned-on, the first control node Q may be deactivated by the gate-off voltage Voff.

The sixth transistor T6 of the node controller may output the gate-on voltage Von of the first power line in response to the control of the second clock signal ECLK2 of the second clock line. The sixth transistor T6 may supply the output voltage to a gate electrode of the fifth transistor T5, and may supply the output voltage to a connection node to which a second electrode of the eighth transistor T8 and a gate electrode of the ninth transistor T9 are connected.

The seventh transistor T7 of the node controller may connect the second control node QB and the second power line supplied with the gate-off voltage Voff in response to the control of the first control node Q. When the seventh transistor T7 is turned-on under the control of the first control node Q, the second control node QB may be deactivated by the gate-off voltage Voff.

The eighth transistor T8 of the node controller may connect the second clock line supplied with the second clock signal CLK2 and the gate electrode of the ninth transistor T9 in response to the control of the first control node Q.

The ninth transistor T9 of the node controller may connect the first clock line supplied with the first clock signal ECLK1 and a first electrode of the tenth transistor T10 in response to the control of the connection node to which the second electrode of the eighth transistor T8 and the gate electrode of the ninth transistor T9 are connected.

The tenth transistor T10 of the node controller may connect the second electrode of the ninth transistor T9 and the second control node QB in response to the control of the first clock signal ECLK1 of the first clock line. When the ninth and tenth transistors T9 and T10 are turned-on, the second control node QB may be activated by the first clock signal CLK1.

As described above, the display panel and the display apparatus according to some embodiments of the present disclosure selectively drive the first light emitting element corresponding to the first lens region and the second light emitting element corresponding to the second lens region in each subpixel of the plurality of areas of the display area by using the light emitting control signals, thereby controlling the viewing angle in each of the plurality of areas to provide the wide viewing angle or narrow viewing angle.

According to some embodiments of the present disclosure, the display panel and the display apparatus independently control the viewing angle of each of the plurality of areas to provide the wide viewing angle or narrow viewing angle by using the plurality of light emitting control signals so that it is possible to adjust the ratio (area) of the wide viewing angle area and the narrow viewing angle area, thereby providing an image of a desired size having a desired viewing angle to a user or users.

A display panel according to some embodiments may include a display area including a first area in which first subpixels are disposed and a second area in which second subpixels are disposed, wherein each of the first and second subpixels includes: a first light emitting element driven through a first light emitting control transistor, a second light emitting element driven through a second light emitting control transistor, a first lens region disposed on the first light emitting element, and a second lens region disposed on the second light emitting element, wherein the first lens region and the second lens region differently control a viewing angle in a first direction, the first light emitting control transistor of the first subpixel is controlled by a first light emitting control signal, the second light emitting control transistor of the first subpixel is controlled by a second light emitting control signal, the first light emitting control transistor of the second subpixel is controlled by a third light emitting control signal, and the second light emitting control transistor of the second subpixel is controlled by a fourth light emitting control signal.

According to some embodiments, the display panel may further include a first emission control driver disposed in a bezel area corresponding to the periphery of the display area and configured to supply the first light emitting control signal activated or deactivated according to a first start signal, a second emission control driver configured to supply the second light emitting control signal activated or deactivated according to a second start signal, a third emission control driver configured to supply the third light emitting control signal activated or deactivated according to a third start signal, and a fourth emission control driver configured to supply the fourth light emitting control signal activated or deactivated according to a fourth start signal.

According to some embodiments, the first area may control a viewing angle of the first direction to a wide viewing angle when the first light emitting control signal is activated, the first area may control a viewing angle of the first direction to a narrow viewing angle whose angle is narrower than that of the wide viewing angle when the second light emitting control signal is activated, the second area may control a viewing angle of the first direction to the wide viewing angle when the third light emitting control signal is activated, and a third area may control a viewing angle of the first direction to the narrow viewing angle when the fourth light emitting control signal is activated.

According to some embodiments, the display area further includes a third area in which third subpixels are arranged, and a fourth area in which fourth subpixels are arranged, each of the first to fourth subpixels has the same configuration, a first emission control transistor of the third subpixel is controlled by a fifth light emitting control signal, a second light emitting control transistor of the third subpixel is controlled by a sixth light emitting control signal, a first emission control transistor of the fourth subpixel is controlled by a seventh light emitting control signal, and a second emission control transistor of the fourth subpixel is controlled by an eighth light emitting control signal.

According to some embodiments, the display panel may further include a first emission control driver configured to supply the first light emitting control signal activated or deactivated according to a first start signal, a second emission control driver configured to supply the second light emitting control signal activated or deactivated according to a second start signal, a third emission control driver configured to supply the third light emitting control signal activated or deactivated according to a third start signal, a fourth emission control driver configured to supply the fourth light emitting control signal activated or deactivated according to a fourth start signal, a fifth emission control driver configured to supply the fifth light emitting control signal activated or deactivated according to a fifth start signal, a sixth emission control driver configured to supply the sixth light emitting control signal activated or deactivated according to a sixth start signal, a seventh emission control driver configured to supply the seventh light emitting control signal activated or deactivated according to a seventh start signal, and an eighth emission control driver configured to supply the eighth light emitting control signal activated or deactivated according to an eighth start signal.

According to some embodiments, the first to fourth emission control drivers may be disposed in a first bezel area located in the periphery of the display area, and the fifth and sixth emission control drivers may be disposed in a second bezel area located in the periphery of the display area.

According to some embodiments, the first area may control a viewing angle of the first direction in a wide viewing angle when the first light emitting control signal is activated, the first area may control a viewing angle of the first direction in a narrow viewing angle when the second light emitting control signal is activated, the second area may control a viewing angle of the first direction in the wide viewing angle when the third light emitting control signal is activated, the third area may control a viewing angle of the first direction in the narrow viewing angle when the fourth light emitting control signal is activated, third region may control a viewing angle of the first direction in the wide viewing angle when the fifth light emitting control signal is activated, the third area may control a viewing angle of the first direction in the narrow viewing angle when the sixth light emitting control signal is activated, the fourth area may control a viewing angle of the first direction in the wide viewing angle when the seventh light emitting control signal is activated, and the fifth area may control a viewing angle of the first direction in the narrow viewing angle when the eighth light emitting control signal is activated.

According to some embodiments, the first lens region may include a semi-cylindrical first lens for controlling a viewing angle of the first direction in the wide viewing angle, and the second lens region may include a hemispherical second lens for controlling a viewing angle of the first direction in the narrow viewing angle.

According to some embodiments, the first light emitting element may include a first light emitting region, and the first lens overlaps the first light emitting region and has a bottom surface which is wider than the first light emitting region.

According to some embodiments, the second light emitting element may include a plurality of second light emitting regions, the second lens region may include a plurality of second lenses overlapping the plurality of second light emitting regions, and each of the plurality of second lenses may have a bottom surface which is wider than each of the plurality of second light emitting regions.

According to some embodiments, the first subpixels and the second subpixels may include a first color subpixel, a second color subpixel, and a third color subpixel, the first lens in the respective first, second, and third color subpixels may have the different sizes, and the number of second lenses in each of the first, second, and third color subpixels may be different from each other.

A display apparatus according to some embodiments may include a display panel with a display area including a first area in which first subpixels are disposed and a second area in which second subpixels are disposed, wherein each of the first and second subpixels includes: a first light emitting element driven through a first light emitting control transistor, a second light emitting element driven through a second light emitting control transistor, a first lens region disposed in a light traveling path of the first light emitting element, and a second lens region disposed in a light traveling path of the second light emitting element, wherein the first lens region and the second lens region control different viewing angles in a first direction, and a first emission control driver configured to supply a first light emitting control signal for controlling the first light emitting control transistor of the first subpixel, a second emission control driver configured to supply a second light emitting control signal for controlling the second light emitting control transistor of the first subpixel, a third emission control driver configured to supply a third light emitting control signal for controlling the first light emitting control transistor of the second subpixel, and a fourth emission control driver configured to supply a fourth light emitting control signal for controlling the second light emitting control transistor of the second subpixel.

According to some embodiments, the first area may control a viewing angle of the first direction to a wide viewing angle when the first light emitting control signal is activated, the first area may control a viewing angle of the first direction to a narrow viewing angle when the second light emitting control signal is activated, the second area may control a viewing angle of the first direction to the wide viewing angle when the third light emitting control signal is activated, and a third area may control a viewing angle of the first direction to the narrow viewing angle when the fourth light emitting control signal is activated.

According to some embodiments, the first to fourth emission control drivers may be disposed in a bezel area located in the periphery of the display area of the display panel.

According to some embodiments, the display area further includes: a third area in which third subpixels are arranged, and a fourth area in which fourth subpixels are arranged, wherein each of the first to fourth subpixels has the same configuration, a fifth emission control driver configured to supply a fifth light emitting control signal for controlling the first light emitting control transistor of the third subpixel, a sixth emission control driver configured to supply a sixth light emitting control signal for controlling the second light emitting control transistor of the third subpixel, a seventh emission control driver configured to supply a seventh light emitting control signal for controlling the first emission control transistor of the fourth subpixel, and an eighth emission control driver configured to supply an eighth light emitting control signal for controlling the second emission control transistor of the fourth subpixel.

According to some embodiments, the first to fourth emission control drivers may be disposed in a first bezel area located in the periphery of the display area of the display panel, and the fifth and sixth emission control drivers may be disposed in a second bezel area located in the periphery of the display area of the display panel.

According to some embodiments, the first area may control a viewing angle of the first direction in a wide viewing angle when the first light emitting control signal is activated, the first area may control a viewing angle of the first direction in a narrow viewing angle when the second light emitting control signal is activated, the second area may control a viewing angle of the first direction in the wide viewing angle when the third light emitting control signal is activated, the third area may control a viewing angle of the first direction in the narrow viewing angle when the fourth light emitting control signal is activated, third region may control a viewing angle of the first direction in the wide viewing angle when the fifth light emitting control signal is activated, the third area may control a viewing angle of the first direction in the narrow viewing angle when the sixth light emitting control signal is activated, the fourth area may control a viewing angle of the first direction in the wide viewing angle when the seventh light emitting control signal is activated, and the fifth area may control a viewing angle of the first direction in the narrow viewing angle when the eighth light emitting control signal is activated.

According to some embodiments, each of the subpixels of the display area may further includes: a storage capacitor configured to charge a driving voltage corresponding to a data voltage, a driving transistor configured to generate a driving current according to the driving voltage stored in the storage capacitor, to supply the driving current to the first light emitting element through the first light emitting control transistor, or to supply the driving current to the second light emitting element through the second light emitting control transistor, and a first switching transistor configured to supply the data voltage to the storage capacitor in response to a first scan signal, wherein a scan driver for supplying the first scan signal is additionally provided.

According to some embodiments, each subpixel may further includes: a second switching transistor configured to connect the driving transistor in a diode structure in response to a second scan signal, a third switching transistor configured to supply an initialization voltage to an anode of the first light emitting element in response to the second scan signal, a fourth switching transistor configured to supply the initialization voltage to an anode of the second light emitting element in response to the second scan signal, and a fifth switching transistor configured to supply the initialization voltage to a first electrode of the storage capacitor in response to a light emitting control signal, wherein a scan driver configured to supply the second scan signal and an emission control driver configured to supply the light emitting control signal are additionally provided.

According to some embodiments, the first light emitting element may include a first light emitting region, and the first lens region may include a semi-cylindrical first lens overlapped with the first light emitting region and configured to have a bottom surface which is wider than that of the first light emitting region, and the second light emitting element may include a plurality of second light emitting regions, and the second lens region may include a p plurality of second lenses respectively overlapped with the plurality of second light emitting regions, wherein each of the second lenses may have a bottom surface which is wider than that of the second light emitting region.

According to some embodiments, the first subpixels and the second subpixels may include a first color subpixel, a second color subpixel, and a third color subpixel, the first lens in the respective first, second, and third color subpixels may have the different sizes, and the number of second lenses in each of the first, second, and third color subpixels may be different from each other.

The display panel and the display apparatus according to one or more embodiments of the present disclosure may be applied to various electronic devices. For example, the display panel and the display apparatus according to one or more embodiments of the present disclosure may be applied to a mobile device, a video phone, a smart watch, a watch phone, a wearable device, a foldable device, a rollable device, a bendable device, a flexible device, a curved device, an electronic diary, electronic book, a portable multimedia player (PMP), a personal digital assistant(PDA), MP3 player, a mobile medical device, a desktop PC, a laptop PC, a netbook computer, a workstation, a navigator, a vehicle navigator, a vehicle display device, a television, a wall paper display device, a signage device, a game device, a notebook computer, a monitor, a camera, a camcorder, and home appliances.

It will be apparent to those skilled in the art that various substitutions, modifications, and variations are possible within the scope of the present disclosure without departing from the scope of the present disclosure. Therefore, the scope of the present disclosure is represented by the following claims, and all changes or modifications derived from the meaning, range and equivalent concept of the claims should be interpreted as being included in the scope of the present disclosure.

The disclosure comprises the following clauses:
1. A display panel comprising:
   a display area including a first area in which first subpixels are disposed and a second area in which second subpixels are disposed,
   wherein each of the first and second subpixels includes a respective instance of:
      a first light emitting element configured to be driven using a first light emitting control transistor;
      a second light emitting element configured to be driven using a second light emitting control transistor;
      wherein, if the first light emitting control transistor of one of the first subpixels is activated, the first area is configured to provide a first viewing angle of light emitted from the first light emitting element;
      wherein, if the second light emitting control transistor of one of the first subpixels is activated, the first area is configured to provide a second viewing angle of light emitted from the second light emitting element, the second viewing angle being different to the first viewing angle;
      wherein, if the first light emitting control transistor of one of the second subpixels is activated, the second area is configured to provide the first viewing angle; and
      wherein, if the second light emitting control transistor of one of the second subpixels is activated, the second area is configured to provide the second viewing angle.
2. The display panel of clause 1, wherein the second viewing angle is narrower than the first viewing angle.
3. The display panel of clause 1 or clause 2, further comprising:
   a first optical control element disposed on the first light emitting element; and
   a second optical control element disposed on the second light emitting element,
   wherein the first optical control element is configured to provide the first viewing angle and the second optical control element is configured to provide the second viewing angle.
4. The display panel according to any previous clause, further comprising:
   a driving transistor,
   wherein a first electrode of the driving transistor is connected to a power line for supplying a first power voltage,
   wherein a second electrode of the driving transistor is connected to a first electrode of the first light emitting control transistor and a first electrode of the second light emitting control transistor,
   wherein a second electrode of the first light emitting control transistor is connected to the first light emitting element, and
   wherein a second electrode of the second light emitting control transistor is connected to the second light emitting element.
5. The display panel of any previous clause, wherein the first light emitting control transistor of the one of the first subpixels is controllable by a first light emitting control signal,
   the second light emitting control transistor of the one of the first subpixels is controllable by a second light emitting control signal,
   the first light emitting control transistor of the one of the second subpixels is controllable by a third light emitting control signal, and
   the second light emitting control transistor of the one of the second subpixels is controllable by a fourth light emitting control signal.
6. The display panel according to clause 5, further comprising:
   a first emission control driver configured to supply the first light emitting control signal activated or deactivated according to a first start signal;
   a second emission control driver configured to supply the second light emitting control signal activated or deactivated according to a second start signal;
   a third emission control driver configured to supply the third light emitting control signal activated or deactivated according to a third start signal; and
   a fourth emission control driver configured to supply the fourth light emitting control signal activated or deactivated according to a fourth start signal.
7. The display panel according to clause 6, wherein any of the first to fourth emission control drivers are disposed in a bezel area corresponding to a periphery of the display area.
8. The display panel according to any preceding clause,
   wherein the display area further includes a third area in which third subpixels are arranged, and a fourth area in which fourth subpixels are arranged,
   each of the first to fourth subpixels having the same configuration,
   a first light emitting control transistor of one of the third subpixels being controllable by a fifth light emitting control signal,
   a second light emitting control transistor of the one of the third subpixels being controllable by a sixth light emitting control signal,
   a first light emitting control transistor of one of the fourth subpixels being controllable by a seventh light emitting control signal, and
   a second light emitting control transistor of the one of the fourth subpixels being controllable by an eighth light emitting control signal.
9. The display panel according to clause 8, further comprising:
   a first emission control driver configured to supply the first light emitting control signal activated or deactivated according to a first start signal;
   a second emission control driver configured to supply the second light emitting control signal activated or deactivated according to a second start signal;
   a third emission control driver configured to supply the third light emitting control signal activated or deactivated according to a third start signal;
   a fourth emission control driver configured to supply the fourth light emitting control signal activated or deactivated according to a fourth start signal;
   a fifth emission control driver configured to supply the fifth light emitting control signal activated or deactivated according to a fifth start signal;
   a sixth emission control driver configured to supply the sixth light emitting control signal activated or deactivated according to a sixth start signal;
   a seventh emission control driver configured to supply the seventh light emitting control signal activated or deactivated according to a seventh start signal; and
   an eighth emission control driver configured to supply the eighth light emitting control signal activated or deactivated according to an eighth start signal.
10. The display panel according to clause 9,
   wherein the first to fourth emission control drivers are disposed in a first bezel area located in a periphery of the display area, and
   the fifth to eighth emission control drivers are disposed in a second bezel area located in the periphery of the display area.
11. The display panel according to any of clauses 8-10,
   wherein, if the first light emitting control signal is activated, the first area is configured to provide the first viewing angle,
   wherein, if the second light emitting control signal is activated, the first area is configured to provide the second viewing angle,
   wherein, if the third light emitting control signal is activated, the second area is configured to provide the first viewing angle,
   wherein, if the fourth light emitting control signal is activated, the second area is configured to provide the second viewing angle,
   wherein, if the fifth light emitting control signal is activated, the third area is configured to provide the first viewing angle,
   wherein, if the sixth light emitting control signal is activated, the third area is configured to provide the second viewing angle,
   wherein, if the seventh light emitting control signal is activated, the fourth area is configured to provide the first viewing angle, and
   wherein, if the eighth light emitting control signal is activated, the fourth area is configured to provide the second viewing angle.
12. The display panel according to any preceding clause,
   wherein the first optical control element includes a semi-cylindrical first lens for providing the first viewing angle, and
   the second optical control element includes a hemispherical second lens for providing the second viewing angle.
13. The display panel according to clause 12,
   wherein the first light emitting element includes a first light emitting region, and
   the first lens overlaps the first light emitting region and has a bottom surface which is wider than the first light emitting region.
14. The display panel according to clause 12 or clause 13,
   wherein the second light emitting element includes a plurality of second light emitting regions, the second optical control element includes a plurality of second lenses each overlapping a respective second light emitting region of the plurality of second light emitting regions, and
   each of the plurality of second lenses has a bottom surface which is wider than the respective second light emitting region.
15. The display panel according to any of clauses 12-14,
   wherein the first subpixels and the second subpixels each include a respective first color subpixel, a respective second color subpixel, and a respective third color subpixel,
   each of the first lenses in the respective first color subpixels have different sizes to the first lenses in the respective second color subpixels and to the first lenses in the respective third color subpixels, and each of the first lenses in the respective second color subpixels have different sizes to the first lenses in the respective third color subpixels, and
   the number of second lenses in each of the respective first color subpixels is different from the number of second lenses in the respective second color subpixels and to the number of second lenses in the respective third color subpixels, and the number of second lenses in each of the respective second color subpixels is different from the number of second lenses in the respective third color subpixels.
16. A display apparatus comprising:
   a display panel with a display area including a first area in which first subpixels are disposed and a second area in which second subpixels are disposed,
   wherein each of the first and second subpixels includes a respective instance of:
      a first light emitting element configured to be driven using a first light emitting control transistor, a second light emitting element configured to be driven using a second light emitting control transistor,
      wherein, if the first light emitting control transistor of one of the first subpixels is activated, the first area is configured to provide a first viewing angle of light emitted from the first light emitting element;
      wherein, if the second light emitting control transistor of one of the first subpixels is activated, the first area is configured to provide a second viewing angle of light emitted from the second light emitting element, the second viewing angle being different to the first viewing angle;
      wherein, if the first light emitting control transistor of one of the second subpixels is activated, the second area is configured to provide the first viewing angle; and
      wherein, if the second light emitting control transistor of one of the second subpixels is activated, the second area is configured to provide the second viewing angle.
17. The display apparatus of clause 16, wherein the second viewing angle is narrower than the first viewing angle.
18. The display apparatus of clause 16 or clause 17, further comprising:
   a first optical control element disposed in a light traveling path of the first light emitting element, and a second optical control element disposed in a light traveling path of the second light emitting element, wherein the first optical control element is configured to provide the first viewing angle and the second optical control element is configured to provide the second viewing angle.
19. The display apparatus according to any of clauses 16-18, wherein the display apparatus further comprises:
   a driving transistor,
   wherein a first electrode of the driving transistor is connected to a power line for supplying a first power voltage,
   wherein a second electrode of the driving transistor is connected to a first electrode of the first light emitting control transistor and a first electrode of the second light emitting control transistor,
   wherein a second electrode of the first light emitting control transistor is connected to the first light emitting element, and
   wherein a second electrode of the second light emitting control transistor is connected to the second light emitting element.
20. The display apparatus of any of clauses 16-19, wherein the first light emitting control transistor of the one of the first subpixels is controllable by a first light emitting control signal,
   the second light emitting control transistor of the one of the first subpixels is controllable by a second light emitting control signal,
   the first light emitting control transistor of the one of the second subpixels is controllable by a third light emitting control signal, and
   the second light emitting control transistor of the one of the second subpixels is controllable by a fourth light emitting control signal.
21. The display apparatus of clause 20, further comprising:
   a first emission control driver configured to supply the first light emitting control signal for controlling the first light emitting control transistor of the first subpixel;
   a second emission control driver configured to supply the second light emitting control signal for controlling the second light emitting control transistor of the first subpixel;
   a third emission control driver configured to supply the third light emitting control signal for controlling the first light emitting control transistor of the second subpixel; and
   a fourth emission control driver configured to supply the fourth light emitting control signal for controlling the second light emitting control transistor of the second subpixel.
22. The display apparatus according to clause 21,
   wherein the first to fourth emission control drivers are disposed in a bezel area located in the periphery of the display area of the display panel.
23. The display apparatus according to clause 22,
   wherein the display area further includes:
   a third area in which third subpixels are arranged, and a fourth area in which fourth subpixels are arranged, wherein each of the first to fourth subpixels has the same configuration;
   a fifth emission control driver configured to supply a fifth light emitting control signal for controlling the first light emitting control transistor of one of the third subpixels;
   a sixth emission control driver configured to supply a sixth light emitting control signal for controlling the second light emitting control transistor of one of the third subpixels;
   a seventh emission control driver configured to supply a seventh light emitting control signal for controlling the first emission control transistor of one of the fourth subpixels; and
   an eighth emission control driver configured to supply an eighth light emitting control signal for controlling the second emission control transistor of one of the fourth subpixels.
24. The display apparatus according to clause 23,
   wherein the first to fourth emission control drivers are disposed in a first bezel area located in the periphery of the display area of the display panel, and
   the fifth to eighth emission control drivers are disposed in a second bezel area located in the periphery of the display area of the display panel.
25. The display apparatus according to any of clauses 22-24,
   wherein, if the first light emitting control signal is activated, the first area is configured to provide the first viewing angle,
   wherein, if the second light emitting control signal is activated, the first area is configured to provide the second viewing angle,
   wherein, if the third light emitting control signal is activated, the second area is configured to provide the first viewing angle,
   wherein, if the fourth light emitting control signal is activated, the second area is configured to provide the second viewing angle,
   wherein, if the fifth light emitting control signal is activated, the third area is configured to provide the first viewing angle,
   wherein, if the sixth light emitting control signal is activated, the third area is configured to provide the second viewing angle,
   wherein, if the seventh light emitting control signal is activated, the fourth area is configured to provide the first viewing angle, and
   wherein, if the eighth light emitting control signal is activated, the fifth area is configured to provide the second viewing angle.
26. The display apparatus according to any of clauses 16-25,
   wherein each of the subpixels of the display area further includes a respective instance of:
   a storage capacitor configured to store a driving voltage corresponding to a data voltage;
   a driving transistor configured to generate a driving current according to the driving voltage stored in the storage capacitor, and to supplying the driving current to the first light emitting element through the first light emitting control transistor, or to supplying the driving current to the second light emitting element through the second light emitting control transistor; and
   a first switching transistor configured to supply the data voltage to the storage capacitor in response to a first scan signal, the display panel further comprising a scan driver configured to supply the first scan signal.
27. The display apparatus according to clause 26,
   wherein each subpixel further includes a respective instance of:
   a second switching transistor configured to connect the driving transistor to a diode structure in response to a second scan signal;
   a third switching transistor configured to supply an initialization voltage to an anode of the first light emitting element in response to the second scan signal;
   a fourth switching transistor configured to supply the initialization voltage to an anode of the second light emitting element in response to the second scan signal; and
   a fifth switching transistor configured to supply the initialization voltage to a first electrode of the storage capacitor in response to a light emitting control signal,
   wherein the scan driver is configured to supply the second scan signal, and wherein the display panel comprises an emission control driver configured to supply the light emitting control signal.
28. The display apparatus according to any of clauses 16-27,
   wherein the first light emitting element includes a first light emitting region, and the first optical control element includes a semi-cylindrical first lens overlapped with the first light emitting region and configured to have a bottom surface which is wider than that of the first light emitting region, and
   wherein the second light emitting element includes a plurality of second light emitting regions, and the second optical control element includes a plurality of second lenses each overlapping a respective second light emitting region of the plurality of second light emitting regions, wherein each of the second lenses has a bottom surface which is wider than that of the respective second light emitting region.
29. The display apparatus according to clause 28,
   wherein the first subpixels and the second subpixels each include a respective first color subpixel, a respective second color subpixel, and a respective third color subpixel,
   each of the first lenses in the respective first color subpixels have different sizes to the first lenses in the respective second color subpixels and to the first lenses in the respective third color subpixels, and each of the first lenses in the respective second color subpixels have the different sizes to the first lenses in the respective third color subpixels, and
   the number of second lenses in each of the respective first color subpixels is different from the number of second lenses in the respective second color subpixels and to the number of second lenses in the respective and third color subpixels and the number of second lenses in each of the respective second color subpixels is different from the number of second lenses in the respective third color subpixels.

## Claims

1. A display panel (100) comprising:
a display area (DA) including a first area (DA1, A1, PA1) in which first subpixels (SP) are disposed and a second area (DA2, A2, PA2) in which second subpixels (SP) are disposed,
wherein each of the first and second subpixels includes a respective instance of:
a first light emitting element (EL1) configured to be driven using a first light emitting control transistor (ET1);
a second light emitting element (EL2) configured to be driven using a second light emitting control transistor (ET2);
wherein, if the first light emitting control transistor (ET1) of one of the first subpixels (SP) is activated, the first area (DA1, A1, PA1) is configured to provide a first viewing angle of light emitted from the first light emitting element;
wherein, if the second light emitting control transistor (ET2) of one of the first subpixels (SP) is activated, the first area is configured to provide a second viewing angle of light emitted from the second light emitting element, the second viewing angle being different to the first viewing angle;
wherein, if the first light emitting control transistor (ET1) of one of the second subpixels (SP) is activated, the second area (DA2, A2, PA2) is configured to provide the first viewing angle; and
wherein, if the second light emitting control transistor (ET2) of one of the second subpixels (SP) is activated, the second area is configured to provide the second viewing angle.

2. The display panel of claim 1, wherein the second viewing angle is narrower than the first viewing angle.

3. The display panel of claim 1 or claim 2, further comprising:
a first optical control element (BWE, RWE, GWE) disposed on the first light emitting element; and
a second optical control element (BNE, RNE, GNE) disposed on the second light emitting element,
wherein the first optical control element is configured to provide the first viewing angle and the second optical control element is configured to provide the second viewing angle.

4. The display panel (100) according to any previous claim, further comprising:
a driving transistor (DT),
wherein a first electrode of the driving transistor is connected to a power line (17) for supplying a first power voltage,
wherein a second electrode of the driving transistor is connected to a first electrode of the first light emitting control transistor (ET1) and a first electrode of the second light emitting control transistor (ET2),
wherein a second electrode of the first light emitting control transistor (ET1) is connected to the first light emitting element (EL1), and
wherein a second electrode of the second light emitting control transistor (ET2) is connected to the second light emitting element (EL2).

5. The display panel of any previous claim, wherein the first light emitting control transistor (ET1) of the one of the first subpixels is controllable by a first light emitting control signal (EM1),
the second light emitting control transistor (ET2) of the one of the first subpixels is controllable by a second light emitting control signal (EM2),
the first light emitting control transistor (ET1) of the one of the second subpixels is controllable by a third light emitting control signal (EM3), and
the second light emitting control transistor (ET2) of the one of the second subpixels is controllable by a fourth light emitting control signal (EM4).

6. The display panel (100) according to claim 5, further comprising:
a first emission control driver (EMD1) configured to supply the first light emitting control signal (EM1) activated or deactivated according to a first start signal (EVST1);
a second emission control driver (EMD2) configured to supply the second light emitting control signal (EM2) activated or deactivated according to a second start signal (EVST2);
a third emission control driver (EMD3) configured to supply the third light emitting control signal (EM3) activated or deactivated according to a third start signal (EVST3); and
a fourth emission control driver (EMD4) configured to supply the fourth light emitting control signal (EM4) activated or deactivated according to a fourth start signal (EVST4).

7. The display panel according to claim 6, wherein any of the first to fourth emission control drivers (EMD1, EMD2, EMD3, EMD4) are disposed in a bezel area (BZ1, BZ2, BZ3, BZ4) corresponding to a periphery of the display area (DA).

8. The display panel (100) according to any preceding claim,
wherein the display area (DA) further includes a third area (A3, PA3) in which third subpixels (SP) are arranged, and a fourth area (A4, PA4) in which fourth subpixels (SP) are arranged,
each of the first to fourth subpixels having the same configuration,
a first light emitting control transistor (ET1) of one of the third subpixels being controllable by a fifth light emitting control signal (EM5),
a second light emitting control transistor (ET2) of the one of the third subpixels being controllable by a sixth light emitting control signal (EM6),
a first light emitting control transistor (ET1) of one of the fourth subpixels being controllable by a seventh light emitting control signal (EM7), and
a second light emitting control transistor (ET2) of the one of the fourth subpixels being controllable by an eighth light emitting control signal (EM8).

9. The display panel (100) according to claim 8, further comprising:
a first emission control driver (EMD1) configured to supply the first light emitting control signal (EM1) activated or deactivated according to a first start signal (EVST1);
a second emission control driver (EMD2) configured to supply the second light emitting control signal (EM2) activated or deactivated according to a second start signal (EVST2);
a third emission control driver (EMD3) configured to supply the third light emitting control signal (EM3) activated or deactivated according to a third start signal (EVST3);
a fourth emission control driver (EMD4) configured to supply the fourth light emitting control signal (EM4) activated or deactivated according to a fourth start signal (EVST4);
a fifth emission control driver (EMD5) configured to supply the fifth light emitting control (EM5) signal activated or deactivated according to a fifth start signal (EVST5);
a sixth emission control driver (EMD6) configured to supply the sixth light emitting control signal (EM6) activated or deactivated according to a sixth start signal (EVST6);
a seventh emission control driver (EMD7) configured to supply the seventh light emitting control signal (EM7) activated or deactivated according to a seventh start signal (EVST7); and
an eighth emission control driver (EMD8) configured to supply the eighth light emitting control signal (EM8) activated or deactivated according to an eighth start signal (EVST8).

10. The display panel (100) according to claim 9,
wherein the first to fourth emission control drivers (EMD1, EMD2, EMD3, EMD4) are disposed in a first bezel area (BZ1) located in a periphery of the display area (DA), and
the fifth to eighth emission control drivers (EMD5, EMD6, EMD7, EMD8) are disposed in a second bezel area (BZ2) located in the periphery of the display area.

11. The display panel (100) according to any of claims 8-10,
wherein, if the first light emitting control signal (EM1) is activated, the first area (A1, PA1) is configured to provide the first viewing angle,
wherein, if the second light emitting control signal (EM2) is activated, the first area is configured to provide the second viewing angle,
wherein, if the third light emitting control signal (EM3) is activated, the second area (A2, PA2) is configured to provide the first viewing angle,
wherein, if the fourth light emitting control signal (EM4) is activated, the second area is configured to provide the second viewing angle,
wherein, if the fifth light emitting control signal (EM5) is activated, the third area (A3, PA3) is configured to provide the first viewing angle,
wherein, if the sixth light emitting control signal (EM6) is activated, the third area is configured to provide the second viewing angle,
wherein, if the seventh light emitting control signal (EM7) is activated, the fourth area (A4, PA4) is configured to provide the first viewing angle, and
wherein, if the eighth light emitting control signal (EM8) is activated, the fourth area is configured to provide the second viewing angle.

12. The display panel (100) according to any preceding claim,
wherein the first optical control element (BWE, RWE, GWE) includes a semi-cylindrical first lens (LZ1) for providing the first viewing angle, and
the second optical control element (BNE, RNE, GNE) includes a hemispherical second lens (LZ2) for providing the second viewing angle.

13. The display panel (100) according to claim 12,
wherein the first light emitting element (EL1) includes a first light emitting region (BE1, RE1, GE1), and the first lens (LZ1) overlaps the first light emitting region and has a bottom surface which is wider than the first light emitting region.

14. The display panel (100) according to claim 12 or claim 13,
wherein the second light emitting element (EL2) includes a plurality of second light emitting regions (BE2, RE2, GE2),
the second optical control element (BNE, RNE, GNE) includes a plurality of second lenses (LZ2) each overlapping a respective second light emitting region of the plurality of second light emitting regions, and
each of the plurality of second lenses has a bottom surface which is wider than the respective second light emitting region.

15. The display panel (100) according to any of claims 12-14,
wherein the first subpixels (SP) and the second subpixels (SP) each include a respective first color subpixel, a respective second color subpixel, and a respective third color subpixel,
each of the first lenses (LZ1) in the respective first color subpixels have different sizes to the first lenses in the respective second color subpixels and to the first lenses in the respective third color subpixels, and each of the first lenses in the respective second color subpixels have different sizes to the first lenses in the respective third color subpixels, and
the number of second lenses (LZ2) in each of the respective first color subpixels is different from the number of second lenses in the respective second color subpixels and to the number of second lenses in the respective third color subpixels, and the number of second lenses in each of the respective second color subpixels is different from the number of second lenses in the respective third color subpixels.

16. A display apparatus (1000) comprising the display panel (100) of any preceding claim and configured to be mounted in a dashboard of a vehicle.
